# EUROPEAN PATENT APPLICATION

(11) **EP 4 550 964 A1**
(43) Date of publication of application: **07.05.2025**
(21) Application number: 24208352.5
(22) Date of filing: 23.10.2024
(51) Int. Cl.: H10B 12/00

(54) **SEMICONDUCTOR DEVICE INCLUDING BIT LINES**

(30) Priority: 01.11.2023 KR 20230149279
(71) Applicant: Samsung Electronics Co., Ltd., Suwon-si, Gyeonggi-do 16677 (KR)
(72) Inventor: SONG, Suyoun, 16677 Suwon-si, Gyeonggi-do (KR); KOO, Jamin, 16677 Suwon-si, Gyeonggi-do (KR); KIM, Beomseo, 16677 Suwon-si, Gyeonggi-do (KR); KIM, Jonghyeok, 16677 Suwon-si, Gyeonggi-do (KR); MOON, Daeyoung, 16677 Suwon-si, Gyeonggi-do (KR); SEO, Changwoo, 16677 Suwon-si, Gyeonggi-do (KR); YOO, Wonseok, 16677 Suwon-si, Gyeonggi-do (KR); CHUNG, Chunhyung, 16677 Suwon-si, Gyeonggi-do (KR)
(74) Representative: Kuhnen & Wacker Patent- und Rechtsanwaltsbüro PartG mbB

(57) **Abstract**

A semiconductor device includes a substrate (110) including a first active region (AC1), a bit line (BL) on the substrate (110) to cross the first active region (AC1), a bit line contact (DC) between the bit line (BL) and the first active region (AC 1) and in a bit line contact hole (DCH) extending into the substrate (110), a bit line contact spacer (160) on a sidewall of the bit line contact (DC) within the bit line contact hole (DCH), a bit line spacer (150) on a sidewall of the bit line (BL), an anti-oxidation layer (138) between the sidewall of the bit line (BL) and the bit line spacer (150) and between the sidewall of the bit line contact (DC) and the bit line spacer (150), and a buried contact (BC) in a buried contact hole (BCH), passing through the bit line contact spacer (160), and contacting the first active region (AC1), in which the anti-oxidation layer (138) includes a silicon-containing material including SiOₓ, where 0 < x ≦ 2.

## Description

### TECHNICAL FIELD

The present inventive concept relates to a semiconductor device, and more particularly, to a semiconductor device including bit lines.

### DISCUSSION OF RELATED ART

The sizes of individual microcircuit patterns for implementing semiconductor devices are being further reduced as the downscaling of semiconductor devices continues. In addition, as integrated circuit devices become highly integrated, the line widths of the bit lines decrease and the spacings between the bit lines also decrease. Therefore, the process for forming contacts between bit lines is becoming increasingly complicated and difficult. Also, to maintain a low resistance for the bit lines with reduced line widths and/or to provide a good electrical connection between components for the formed contacts with small spacings located between bit lines is a challenge.

### SUMMARY

The present inventive concept provides a semiconductor device capable of reducing the difficulty of a process of forming a contact between bit lines.

According to an embodiment of the present inventive concept, there is provided a semiconductor device including a substrate including a first active region, a bit line arranged on the substrate, crossing the first active region, and extending in a first direction parallel to a top surface of the substrate, a bit line contact arranged between the bit line and the first active region and arranged in a bit line contact hole, the bit line contact hole extending into the substrate, a bit line contact spacer arranged on a sidewall of the bit line contact within the bit line contact hole, a bit line spacer arranged on a sidewall of the bit line, an anti-oxidation layer arranged between the sidewall of the bit line and the bit line spacer and between the sidewall of the bit line contact and the bit line spacer, and a buried contact arranged in a buried contact hole, passing through the bit line contact spacer, and contacting the first active region, in which the anti-oxidation layer includes a silicon-containing material, and the silicon-containing material includes SiOₓ, where 0 < x ≦ 2.

According to an embodiment of the present inventive concept, there is provided a semiconductor device including a substrate including a plurality of first active regions, a plurality of bit lines placed on the substrate, crossing the plurality of first active regions, and extending in a first direction parallel to a top surface of the substrate, a bit line contact arranged between a first bit line among the plurality of bit lines and a first active region among the plurality of first active regions, corresponding to the first bit line, and arranged within a bit line contact hole, the bit line contact hole extending into the substrate, an anti-oxidation layer including a first portion arranged on a sidewall of the first bit line and a second portion arranged on an inner wall of the bit line contact hole, a bit line contact spacer arranged on the second portion of the anti-oxidation layer and filling the bit line contact hole, and a buried contact arranged between the first bit line and a second bit line adjacent to the first bit line among the plurality of bit lines, arranged in a buried contact hole, passing through the bit line contact spacer and the second portion of the anti-oxidation layer, and contacting the first active region, in which the anti-oxidation layer includes a silicon-containing material, and the silicon-containing material includes SiOₓ, where 0 < x ≦ 2.

According to an embodiment of the present inventive concept, there is provided a semiconductor device including a substrate including a plurality of first active regions, a plurality of bit lines placed on the substrate, crossing the plurality of first active regions, and extending in a first direction parallel to a top surface of the substrate, a bit line contact arranged between a first bit line among the plurality of bit lines and a first active region among the plurality of first active regions, corresponding to the first bit line, and arranged within a bit line contact hole, the bit line contact hole extending into the substrate, an anti-oxidation layer including a first portion arranged on a sidewall of the first bit line and a second portion arranged on an inner wall of the bit line contact hole, a bit line contact spacer arranged on the second portion of the anti-oxidation layer and filling the bit line contact hole, and a buried contact arranged between the first bit line and a second bit line adjacent to the first bit line among the plurality of bit lines, arranged in a buried contact hole, passing through the bit line contact spacer and the second portion of the anti-oxidation layer, and contacting the first active region, a bit line spacer arranged on a sidewall of the first bit line, the bit line spacer including a first spacer layer arranged on a sidewall of the first portion of the anti-oxidation layer and including silicon oxide, and a second spacer layer arranged on a sidewall of the first spacer layer and including silicon nitride, and a landing pad arranged on the buried contact, in which the anti-oxidation layer includes a silicon-containing material, and the silicon-containing material includes SiOₓ, where 0 < x ≦ 2, and the first portion of the anti-oxidation layer includes silicon oxide (SiO₂).

### BRIEF DESCRIPTION OF THE DRAWINGS

Embodiments of the present inventive concept will be more clearly understood from the following detailed description taken in conjunction with the accompanying drawings in which:
FIG. 1 is a layout diagram illustrating a semiconductor device according to an embodiment of the present inventive concept;
FIG. 2 is an enlarged layout diagram of portion II of FIG. 1;
FIG. 3 is a cross-sectional view taken along line A-A' of FIG. 2;
FIG. 4 is a cross-sectional view taken along line B-B' of FIG. 2;
FIG. 5 is a cross-sectional view taken along line C-C' of FIG. 2;
FIG. 6 is an enlarged view of portion CX1 of FIG. 3;
FIGS. 7 and 8 are cross-sectional views illustrating a semiconductor device according to an embodiment of the present inventive concept;
FIGS. 9 and 10 are cross-sectional views illustrating a semiconductor device according to an embodiment of the present inventive concept; and
FIGS. 11A, 11B, 12A, 12B, 13A, 13B, 14A, 14B, 15 to 21, 22A, 22B, 23A, 23B, 24A, and 24B are cross-sectional views illustrating a method of manufacturing a semiconductor device, according to an embodiment of the present inventive concept, in which, FIGS. 11A, 12A, 13A, 14A, 15 to 21, 22A, 23A, and 24A are cross-sectional views corresponding to a cross-section taken along line A-A' of FIG. 2, and FIGS. 11B, 12B, 13B, 14B, 22B, 23B, and 24B are cross-sectional views corresponding to a cross-section taken along line B-B' of FIG. 2.

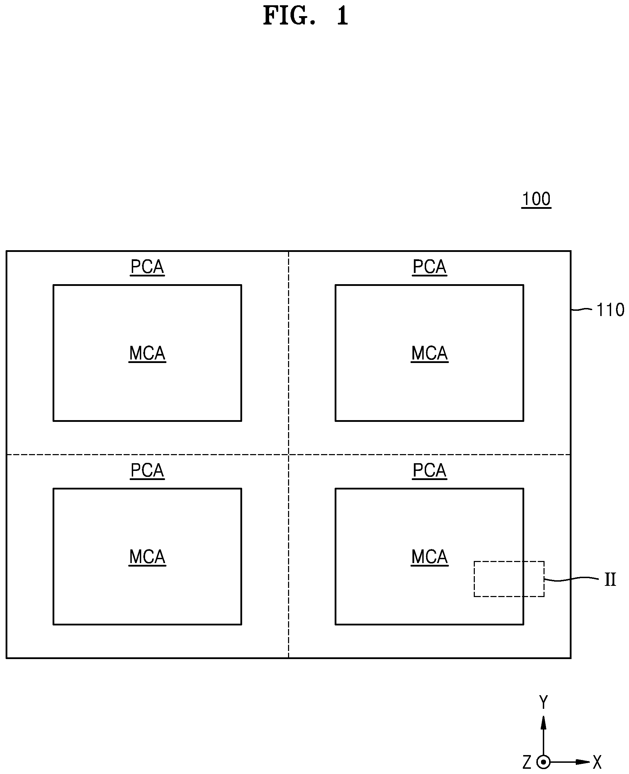

Since the drawings in FIGS. 1-24B are intended for illustrative purposes, the elements in the drawings are not necessarily drawn to scale. For example, some of the elements may be enlarged or exaggerated for clarity purpose.

### DETAILED DESCRIPTION OF THE EMBODIMENTS

Hereinafter, embodiments of the present inventive concept will be described in detail with reference to the accompanying drawings.

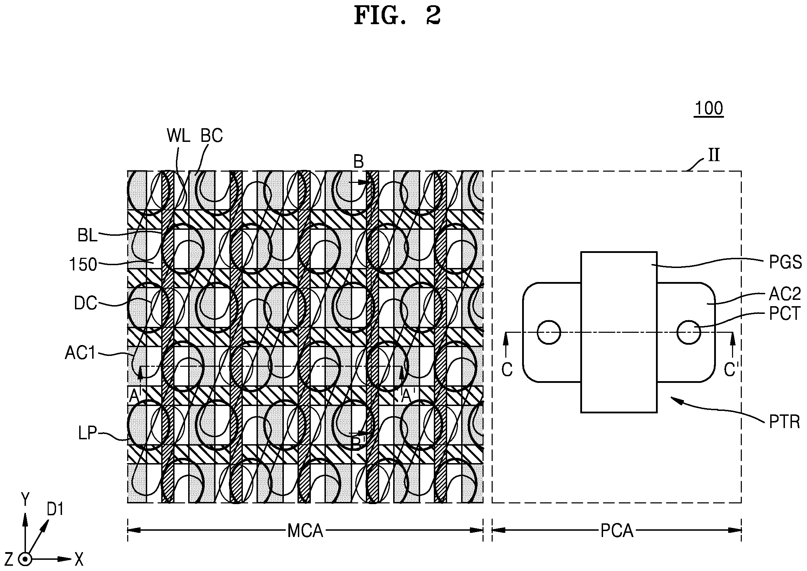

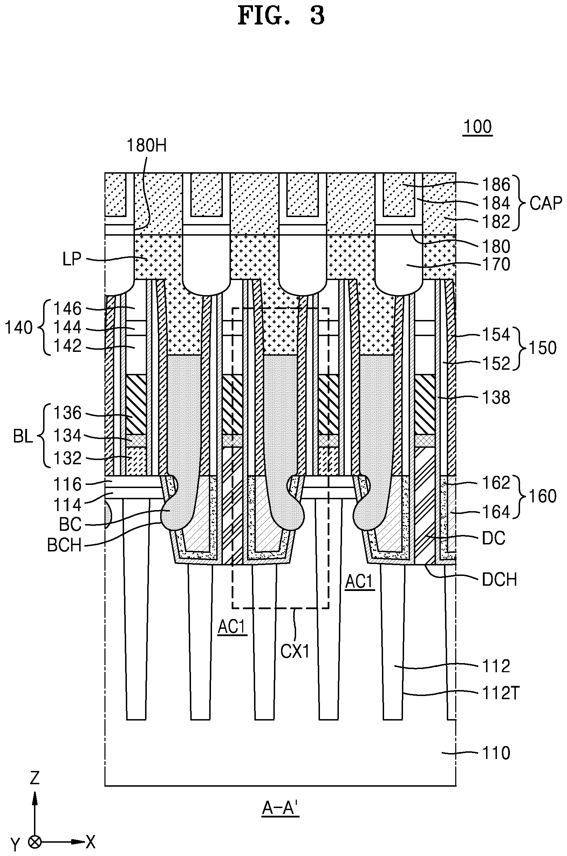

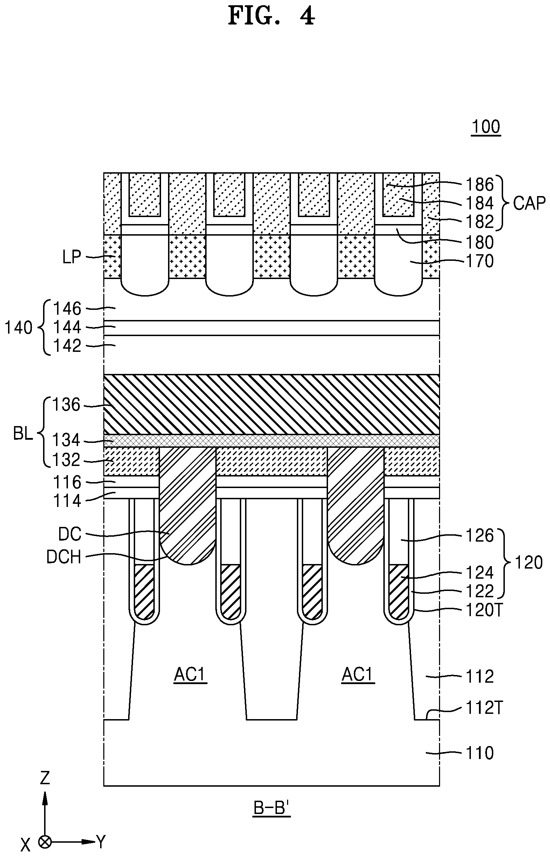

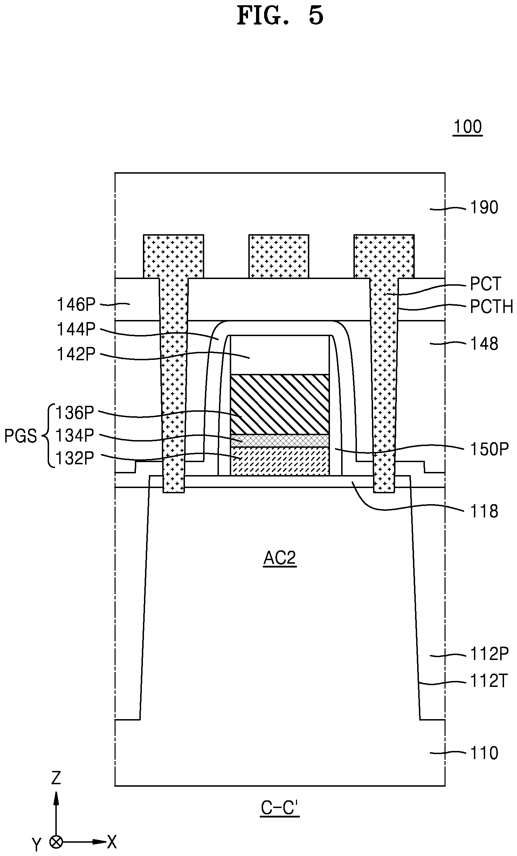

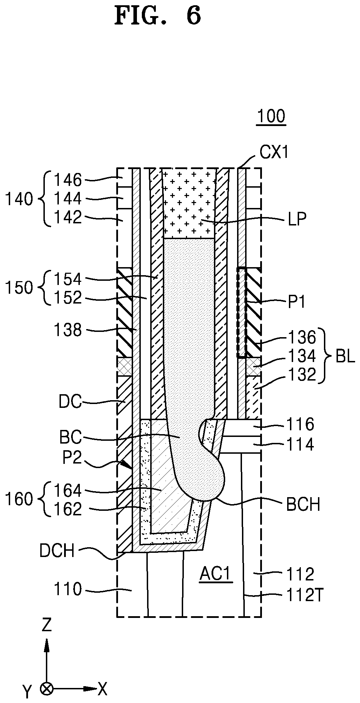

FIG. 1 is a layout diagram illustrating a semiconductor device according to an embodiment of the present inventive concept. FIG. 2 is an enlarged layout diagram of portion II of FIG. 1. FIG. 3 is a cross-sectional view taken along line A-A' of FIG. 2. FIG. 4 is a cross-sectional view taken along line B-B' of FIG. 2. FIG. 5 is a cross-sectional view taken along line C-C' of FIG. 2. FIG. 6 is an enlarged view of portion CX1 of FIG. 3.

Referring to FIGS. 1 to 6, a semiconductor device 100 may include a substrate 110 including cell array regions MCA and peripheral circuit regions PCA. Each of the cell array regions MCA may be a memory cell region of a dynamic random access memory (DRAM) device, and each of the peripheral circuit regions PCA may be a core region or a peripheral circuit region of the DRAM device. For example, each of the cell array regions MCA may include a cell transistor and a capacitor structure CAP connected thereto, and each of the peripheral circuit regions PCA may include a peripheral circuit transistor PTR for transmitting signals and/or power to a cell transistor included in each of the cell array regions MCA. In an embodiment of the present inventive concept, the peripheral circuit transistor PTR may configure various circuits such as, for example, a command decoder, control logic, address buffer, row decoder, column decoder, sense amplifier, data input/output circuit, and the like.

A device isolation trench 112T may be formed in the substrate 110, and a first device isolation layer 112 and a second device isolation layer 112P may be formed in the device isolation trench 112T. A plurality of first active regions AC1 may be defined in each cell array region MCA of the substrate 110 by the first device isolation layer 112, and a plurality of second active regions AC2 may be defined in each peripheral circuit region PCA by the second device isolation layer 112P. For example, the device isolation trench 112T may be arranged on the substrate 110 to surround the plurality of first active regions AC1 in each cell array region MCA and the plurality of second active regions AC2 in each peripheral circuit region PCA.

As shown in FIG. 2, in each cell array region MCA, each of the plurality of first active regions AC1 may be arranged to have a long axis in a first diagonal direction D1 inclined with respect to a first horizontal direction X and a second horizontal direction Y. Thus, the second horizontal direction Y is orthogonal to the first horizontal direction X. The plurality of first active regions AC1 may be disposed in a bar-like form of diagonal lines or oblique lines, as illustrated, and by depositing the plurality of first active regions AC1 in a direction of a diagonal line or an oblique line, a maximum possible distance between contacts may be provided for the semiconductor device 100. A plurality of word lines WL may be spaced apart from each other in the second horizontal direction Y and extend in parallel to each other in the first horizontal direction X across a plurality of first active regions AC1. The plurality of word lines WL may be arranged at a uniform pitch. A plurality of bit lines BL may extend in parallel with each other in the second horizontal direction Y above the plurality of word lines WL, and may be arranged at a uniform pitch. The plurality of bit lines BL may be connected to the plurality of first active regions AC1 through bit line contacts DC, respectively. The bit line contacts DC may each be arranged on a center region of the first active region AC1.

A plurality of buried contacts BC may be formed between two bit lines BL adjacent to each other among the plurality of bit lines BL, and may be arranged on both ends of the plurality of first active regions AC 1. A plurality of landing pads LP may be formed on the plurality of buried contacts BC, respectively. The plurality of buried contacts BC and the plurality of landing pads LP may connect a lower electrode 182 of the capacitor structure CAP formed above the plurality of bit lines BL to a first active region AC1. For example, the plurality of landing pads LP may be arranged between the plurality of buried contacts BC and the lower electrodes 182 of the capacitor structures CAP. The plurality of landing pads LP may be arranged to partially overlap the buried contacts BC and the bit lines BL, respectively.

The substrate 110 may include silicon (Si), for example, single crystalline silicon (sc-Si), polycrystalline silicon (pc-Si), or amorphous silicon (a-Si). The substrate 110 may be a bulk silicon (Si) substrate or a silicon-on-insulator (SOI) substrate. In an embodiment of the present inventive concept, the substrate 110 may include at least one selected from germanium (Ge), silicon germanium (SiGe), silicon carbide (SiC), gallium arsenide (GaAs), indium arsenide (InAs), indium antimonide (InSb), lead telluride (PbTe), gallium phosphide (GaP), gallium antimonide (GaSb) or indium phosphide (InP). In an embodiment of the present inventive concept, the substrate 110 may include a conductive region, such as an impurity-doped well or an impurity-doped structure.

The first device isolation layer 112 may include, for example, an oxide layer, a nitride layer, or a combination thereof. For example, the first device isolation layer 112 may include, for example, a silicon oxide (SiO₂) film, a silicon nitride (Si₃N₄) film, or a combination thereof. A first buffer insulating layer 114 and a second buffer insulating layer 116 may be sequentially arranged on a top surface of the substrate 110. Each of the first buffer insulating layer 114 and the second buffer insulating layer 116 may include, for example, silicon oxide (SiO₂), silicon oxynitride (SiON), or silicon nitride (Si₃N₄).

A plurality of word line trenches 120T extending in the first horizontal direction X may be arranged on the substrate 110, and a buried gate structure 120 may be arranged in a plurality of word line trenches 120T. The buried gate structure 120 may include a gate dielectric layer 122, a gate electrode 124, and a word line capping layer 126 arranged in each of the plurality of word line trenches 120T. The gate dielectric layer 122 may conformally cover an inner surface of a word line trench 120T to contact the first active region AC1 and the first device isolation layer 112, and may extend along a sidewall and a bottom surface of the word line trench 120T. A plurality of gate electrodes 124 may correspond to a plurality of word lines WL illustrated in FIG. 2, respectively.

The plurality of gate dielectric layers 122 may each include, for example, a silicon oxide (SiO₂) layer, a silicon nitride (Si₃N₄) layer, a silicon oxynitride (SiON) layer, an oxide/nitride/oxide (ONO) layer, or a high-k dielectric film having a dielectric constant higher than that of the silicon oxide (SiO₂) layer. The high-k dielectric film may include, for example, hafnium oxide (HfO₂), aluminum oxide (Al₂O₃), hafnium aluminum oxide (HfAlOs), tantalum oxide (Ta₂O₃), lanthanum oxide (La₂O₃), lanthanum aluminum oxide (LaAlO₃), zirconium oxide (ZrO₂), yttrium oxide (Y₂O₃) or titanium oxide (TiO₂), but the present inventive concept is not limited thereto. The plurality of gate electrodes 124 may include, for example, titanium (Ti), titanium nitride (TiN), tantalum (Ta), tantalum nitride (TaN), tungsten (W), tungsten nitride (WN), titanium silicon nitride (TiSiN), tungsten silicon nitride (WSiN), or a combination thereof. The plurality of word line capping layers 126 may each include, for example, a silicon oxide (SiO₂) layer, a silicon nitride (Si₃N₄) layer, a silicon oxynitride (SiON) layer, or a combination thereof.

A plurality of bit line contact holes DCH may extend into the substrate 110 by penetrating the first buffer insulating layer 114 and the second buffer insulating layer 116, and a plurality of bit line contacts DC may be respectively formed in the plurality of bit line contact holes DCH. The plurality of bit line contacts DC may be connected to the plurality of first active regions AC1, respectively. The plurality of bit line contacts DC may include, for example, titanium nitride (TiN), titanium silicon nitride (TiSiN), tungsten (W), tungsten silicide (WSi₂), doped polysilicon (p-Si), or a combination thereof.

The plurality of bit lines BL may extend lenghtwise in the second horizontal direction Y on the substrate 110 and on the plurality of bit line contacts DC. Each of the plurality of bit lines BL may be connected to the first active region AC 1 through each of the bit line contacts DC.

Each of the plurality of bit lines BL may include a lower conductive layer 132, a metal silicide layer 134, and an upper conductive layer 136. Although FIGS. 3 and 4 illustrate that each of the plurality of bit lines BL has a triple layer structure including the lower conductive layer 132, the metal silicide layer 134, and the upper conductive layer 136, the present inventive concept is not limited thereto. For example, each of the plurality of bit lines BL may have a single layer structure, a double layer structure, or a stack structure of a plurality of layers including four or more layers.

The lower conductive layer 132 may extend in the second horizontal direction Y on the second buffer insulating layer 116, and the lower conductive layer 132 may cover both sidewalls of the bit line contact DC, as shown in FIG. 3. For example, as shown in FIG. 4, the top surface of the lower conductive layer 132 may be arranged on a plane the same as that of the top surface of the bit line contact DC, and both sidewalls of the bit line contact DC may be in contact with the lower conductive layer 132. The lower conductive layer 132 may include, for example, silicon (Si), germanium (Ge), tungsten (W), tungsten nitride (WN), cobalt (Co), nickel (Ni), aluminum (Al), molybdenum (Mo), ruthenium (Ru), titanium (Ti), titanium nitride (TiN), tantalum (Ta), tantalum nitride (TaN), copper (Cu), or a combination thereof.

In an embodiment of the present inventive concept, in the process of forming the bit line contact hole DCH, a part of the lower conductive layer 132, a part of the second buffer insulating layer 116, a part of the first buffer insulating layer 114, and a part of the substrate 110 may be removed, and the bit line contact DC may be formed in the bit line contact hole DCH. Accordingly, an upper side of the bit line contact DC may be in contact with the metal silicide layer 134, and a lower side of the bit line contact DC may be in contact with the substrate 110 (e.g., the first active region AC1).

The metal silicide layer 134 may be arranged on the top surface of the lower conductive layer 132 and on the top surface of the bit line contact DC to extend in the second horizontal direction Y. In an embodiment of the present inventive concept, the metal silicide layer 134 may include at least one of, for example, cobalt silicide (CoSi₂), nickel silicide (NiSi₂), titanium silicide (TiSi₂), tantalum silicide (TaSi₂), or tungsten silicide (WSi₂). In an embodiment of the present inventive concept, optionally, a conductive barrier layer of at least one of, for example, titanium (Ti), titanium nitride (TiN), niobium nitride (NbN), tungsten nitride (WN), or tantalum nitride (TaN) may be further arranged on the metal silicide layer 134.

The upper conductive layer 136 may be arranged on the top surface of the metal silicide layer 134 and extend in the second horizontal direction Y. In an embodiment of the present inventive concept, the upper conductive layer 136 may include any one of, for example, tungsten (W), ruthenium (Ru), molybdenum (Mo), titanium (Ti), rhodium (Ro), iridium (Ir), and alloys thereof.

A plurality of bit line capping layers 140 may be arranged on the plurality of bit lines BL, respectively. Each of the bit line capping layers 140 may include a first capping layer 142, a second capping layer 144, and a third capping layer 146 sequentially arranged on the top surface of each of the plurality of bit lines BL. The first capping layer 142, the second capping layer 144, and the third capping layer 146 may include at least one of, for example, silicon nitride (Si₃N₄), silicon oxide (SiO₂), or silicon oxynitride (SiON).

Anti-oxidation layers 138 may be conformally arranged on the sidewalls of each of the plurality of bit lines BL, on the sidewalls of each of the plurality of bit line capping layers 140, and on the inner wall of each of the bit line contact holes DCH. In an embodiment of the present inventive concept, the anti-oxidation layer 138 may be arranged on the sidewall of each of the bit line contacts DC arranged to be aligned with the sidewall of each of the plurality of bit lines BL. Here, as shown in FIG. 6, a portion of the anti-oxidation layer 138 arranged on the sidewall of the upper conductive layer 136 of the bit line BL is referred to as a first portion P1, and a portion of the anti-oxidation layer 138 arranged on the inner wall of the bit line contact hole DCH is referred to as a second portion P2.

In an embodiment of the present inventive concept, the anti-oxidation layers 138 may prevent the sidewall portion of the upper conductive layer 136 of each of the plurality of bit lines BL from being oxidized in a patterning process and/or a cleaning process after the patterning process of the bit lines BL. For example, the anti-oxidation layers 138 may supply a silicon (Si) precursor on the exposed sidewalls of the plurality of bit lines BL after the patterning process of the plurality of bit lines BL, and may include a silicon-containing material formed by a reduction reaction between the supplied silicon (Si) precursor and the metal oxide on the surface of the upper conductive layer 136. For example, the metal oxide may be reduced by the silicon (Si) precursor to regenerate the metal.

In an embodiment of the present inventive concept, each of the anti-oxidation layers 138 may have a thickness of about 0.1 nm to about 2 nm. When the term "about" is used in this specification in connection with a numerical value, it is intended that the associated numerical value includes a tolerance of up to ±10% around the stated numerical value. In an embodiment of the present inventive concept, the anti-oxidation layers 138 may include a silicon-containing material, and the silicon-containing material may be represented by a chemical formula of SiOₓ (0 < x ≦ 2). In an embodiment of the present inventive concept, the anti-oxidation layers 138 may further include impurities of chlorine (Cl) and/or carbon (C). For example, the impurities may be residue of chlorine (Cl) atoms and/or carbon (C) atoms included in the silicon (Si) precursor supplied during the formation process of the anti-oxidation layers 138.

In an embodiment of the present inventive concept, a portion of the anti-oxidation layer 138, for example, the first portion P1 of the anti-oxidation layer 138 arranged on the sidewall of the upper conductive layer 136, may include silicon oxide (SiO₂) formed by a reduction reaction between the supplied silicon precursor and the metal oxide on the surface of the upper conductive layer 136.

For example, the first portion P1 of the anti-oxidation layer 138 may include a material formed by a reduction reaction according to Chemical Equation 1 below.

MOₓ + Si → M + SiO_{y} - (Chemical Equation 1)

Here, M may correspond to an element of a metal material included in the bit lines BL. The anti-oxidation layer 138 including silicon containing material SiO_{y} (0 < y ≦ 2) may be formed on the side wall of the bit line BL. In Chemical Equation 1, x may be equal to y. The upper conductive layer 136 may include the metal material represented by M.

For example, when the upper conductive layer 136 included in the bit line BL includes tungsten (W), the first portion P1 of the anti-oxidation layer 138 including silicon oxide (SiO₂) may be formed on the sidewall of the upper conductive layer 136 by a reduction reaction under Chemical Equation 2 below.

2WO₃ + 3Si → 2W + 3SiO₂ - (Chemical Equation 2)

In an embodiment of the present inventive concept, although the sidewall portion of the upper conductive layer 136 of each of the plurality of bit lines BL is oxidized in the patterning process of the bit lines BL and/or in the cleaning process after the patterning process of the bit lines BL to form tungsten oxide (WO₃) locally on the sidewall portion of the upper conductive layer 136, the tungsten oxide (WO₃) may be reduced to metal tungsten (W) by a reduction reaction of tungsten oxide (WO₃) formed on the sidewall of the upper conductive layer 136 during the process of forming the anti-oxidation layers 138 through the supply of the silicon (Si) precursor. Accordingly, the upper conductive layer 136 may have relatively small electrical resistance.

In an embodiment of the present inventive concept, depending on the amount of metal oxide formed on the sidewall of the bit line BL, when sufficient silicon (Si) precursor is supplied to form the anti-oxidation layer 138 to reduce tungsten oxide (WO₃), the reduction reaction may be represented by Chemical Equation 3 below.

2WO₃ + zSi → 2W + zSiO_{6/z} - (Chemical Equation 3)

In Chemical Equation 3, z is equal to or greater than 3.

Bit line spacers 150 may be arranged on both sidewalls of each bit line BL. The anti-oxidation layers 138 may be arranged between the bit line spacer 150 and the bit line BL and between the bit line spacer 150 and the bit line capping layer 140, respectively. The anti-oxidation layer 138 may also be arranged between the sidewall of the bit line contact DC and the bit line spacer 150 as shown in FIG. 3. The bit line spacer 150 may include a first spacer layer 152 and a second spacer layer 154. In an embodiment of the present inventive concept, the first spacer layer 152 may include silicon oxide (SiO₂) and the second spacer layer 154 may include silicon nitride (Si₃N₄). The first spacer layer 152 may be in contact with the anti-oxidation layer 138, and accordingly, the first spacer layer 152 may not be in contact with the sidewall of the bit line BL.

The second portion P2 of the anti-oxidation layer 138 may conformally extend onto the inner wall of the bit line contact hole DCH to cover or contact the sidewall of the bit line contact DC and the surface of the substrate 110, and a bit line contact spacer 160 may be arranged on the second portion P2 of the anti-oxidation layer 138 in the bit line contact hole DCH.

The bit line contact spacer 160 may include an insulating liner 162 and a buried spacer 164. The insulating liner 162 may be in contact with the second portion P2 of the anti-oxidation layer 138 and may be conformally arranged inside the bit line contact hole DCH. The buried spacer 164 on the insulating liner 162 may fill the inside of the bit line contact hole DCH. In an embodiment of the present inventive concept, the insulating liner 162 may include silicon oxide (SiO₂) and the buried spacer 164 may include silicon nitride (Si₃N₄). For example, the first spacer layer 152 of the bit line spacer 150 and the insulating liner 162 of the bit line contact spacer 160 may include the same material. The second spacer layer 154 of the bit line spacer 150 and the buried spacer 164 of the bit line contact spacer 160 may include the same material.

A plurality of buried contacts BC may be arranged between the plurality of bit lines BL, respectively. For example, an upper side of each of the plurality of buried contacts BC may be placed between two adjacent bit line spacers 150, and the upper side of each of the plurality of buried contacts BC may be in contact with the two adjacent bit line spacers 150. A lower side of each of the plurality of buried contacts BC may be arranged in a buried contact hole BCH, penetrating the bit line contact spacer 160, and extending into the substrate 110. For example, each of the plurality of buried contacts BC and the corresponding buried contact hole BCH may pass through the bit line contact spacer 160. A bottom portion of each of the plurality of buried contacts BC may be in contact with the first active region AC1. In an embodiment of the present inventive concept, the plurality of buried contacts BC may include doped polysilicon (p-Si).

In an embodiment of the present inventive concept, the buried contact hole BCH may extend to penetrate the bit line contact spacer 160 in a direction toward the sidewall of the bit line contact hole DCH, and a bottom portion of the buried contact hole BCH may be arranged to overlap the sidewall of the bit line contact hole DCH. For example, as the buried contact hole BCH extends to penetrate the bit line contact spacer 160 in a direction toward the sidewall of the bit line contact hole DCH, a bottom portion of the buried contact BC may have a curved profile protruding laterally in the direction of the first active region AC1 with respect to the sidewall of the bit line contact hole DCH, as shown in FIG. 6. In an embodiment of the present inventive concept, the bottom portion of the buried contact BC arranged adjacent to the first active region AC1 may be surrounded by the second portion P2 of the anti-oxidation layer 138 and the insulating liner 162. For example, the bottom portion of the buried contact BC may be covered by the buried spacer 164, the insulating liner 162, and the anti-oxidation layer 138. One bit line contact DC and a pair of buried contacts BC, which face each other with the one bit line contact DC arranged therebetween, may be respectively connected to different first active regions AC1 from each other among the plurality of first active regions AC1.

A plurality of insulating fences may be arranged between two adjacent bit lines BLs in the second horizontal direction Y. The plurality of insulating fences may be arranged at positions vertically overlapping a plurality of word line trenches 120T. In a plan view, the plurality of buried contacts BC and the plurality of insulating fences may be alternately arranged between two bit lines BL extending in the second horizontal direction Y. Each of the plurality of insulating fences may have a pillar shape extending in a vertical direction Z between the plurality of bit lines BL, and may include a silicon nitride (Si₃N₄) film. Other insulating film such as, for example, a silicon oxide (SiO₂) film, or a silicon oxynitride (SiON) film may also be used for each of the plurality of insulating fences.

A plurality of landing pads LP may be arranged on the plurality of buried contacts BC, respectively. Each of the plurality of landing pads LP may include a conductive barrier layer and a landing pad conductive layer. The conductive barrier layer may include, for example, titanium (Ti), titanium nitride (TiN), or a combination thereof. The landing pad conductive layer may include, for example, metal, metal nitride, conductive polysilicon (p-Si), or a combination thereof. For example, the landing pad conductive layer may include tungsten (W). The plurality of landing pads LP may have a plurality of island-shaped pattern shapes in a plan view.

The plurality of landing pads LP may be electrically insulated from each other by an insulating pattern 170 surrounding the plurality of landing pads LP. The insulating pattern 170 may include at least one of, for example, silicon nitride (Si₃N₄), silicon oxide (SiO₂), or silicon oxynitride (SiON).

An etching stop layer 180 may be arranged on the insulating pattern 170, and the etching stop layer 180 may include openings 180H. The openings 180H may be arranged at positions corresponding to the respective landing pads LP, and a top surface of each of the landing pads LP may be arranged on the bottom of each of the openings 180H.

A capacitor structure CAP may be arranged on the etching stop layer 180 and the landing pads LP to store electric charges in, for example, a semiconductor memory element. For example, the capacitor structure CAP may be connected to a portion of the upper surface of each of the landing pads LP which is not blocked by the etching stop layer 180. The capacitor structure CAP may include the lower electrode 182, a capacitor dielectric layer 184, and an upper electrode 186. The lower electrode 182 may be arranged such that the bottom of the lower electrode 182 is arranged in each of the openings 180H of the etching stop layer 180 and thus the bottom of the lower electrode 182 is placed on each of the landing pads LP. The capacitor dielectric layer 184 may be arranged thinly to conformally cover the lower electrode 182, and an upper electrode 186 may be arranged on the capacitor dielectric layer 184. The capacitor structure CAP may store electric charges in the capacitor dielectric layer 184 by a potential difference generated between the lower electrode 182 and the upper electrode 186.

The peripheral circuit transistor PTR may be arranged on the second active region AC2 in the peripheral circuit region PCA. As shown in FIGS. 2 and 5, the peripheral circuit transistor PTR may include a gate dielectric layer 118, a peripheral circuit gate stack PGS, and a gate capping pattern 142P, which are sequentially stacked on the second active region AC2.

The gate dielectric layer 118 may be arranged on a top surface of the substrate 110. The gate dielectric layer 118 may include at least one selected from, for example, a silicon oxide (SiO₂) layer, a silicon nitride (Si₃N₄) layer, a silicon oxynitride (SiON) layer, an oxide/nitride/oxide (ONO) layer, or a high-k dielectric film having a dielectric constant higher than that of the silicon oxide (SiO₂) layer. The high-k dielectric film may include, for example, hafnium oxide (HfO₂), aluminum oxide (Al₂O₃), hafnium aluminum oxide (HfAlO₃), tantalum oxide (Ta₂O₃), lanthanum oxide (La₂O₃), lanthanum aluminum oxide (LaAlOs), zirconium oxide (ZrO₂), yttrium oxide (Y₂O₃) or titanium oxide (TiO₂), but the present inventive concept is not limited thereto. The gate capping pattern 142P may be arranged to cover a top surface of the peripheral circuit gate stack PGS. In an embodiment of the present inventive concept, the gate capping pattern 142P may include a silicon nitride (Si₃N₄) layer.

The peripheral circuit gate stack PGS may include a peripheral lower conductive layer 132P, a peripheral metal silicide layer 134P, and a peripheral upper conductive layer 136P.

The peripheral lower conductive layer 132P may be arranged on the gate dielectric layer 118 and may include at least one of, for example, silicon (Si), germanium (Ge), tungsten (W), tungsten nitride (WN), cobalt (Co), nickel (Ni), aluminum (Al), molybdenum (Mo), ruthenium (Ru), titanium (Ti), titanium nitride (TiN), tantalum (Ta), tantalum nitride (TaN), copper (Cu), or a combination thereof. The peripheral metal silicide layer 134P may be arranged on the top surface of the peripheral lower conductive layer 132P. In an embodiment of the present inventive concept, the peripheral metal silicide layer 134P may include at least one of, for example, cobalt silicide (CoSi₂), nickel silicide (NiSi₂), titanium silicide (TiSi₂), tantalum silicide (TaSi₂), or tungsten silicide (WSi₂). In an embodiment of the present inventive concept, optionally, at least one conductive barrier layer of, for example, titanium (Ti), titanium nitride (TiN), niobium nitride (NbN), tungsten nitride (WN), or tantalum nitride (TaN) may be further arranged on the peripheral metal silicide layer 134P.

In an embodiment of the present inventive concept, the peripheral upper conductive layer 136P may include at least one of, for example, tungsten (W), ruthenium (Ru), molybdenum (Mo), titanium (Ti), rhodium (Ro), iridium (Ir), or alloys thereof.

In an embodiment of the present inventive concept, the constituent materials of each of the peripheral lower conductive layer 132P, the peripheral metal silicide layer 134P, and the peripheral upper conductive layer 136P may be the same as those of the lower conductive layer 132, the metal silicide layer 134, and the upper conductive layer 136 included in each of the bit lines BL in the cell array region MCA, respectively. For example, the peripheral circuit gate stack PGS may be simultaneously formed in a process of forming the bit lines BL. However, the present inventive concept is not limited thereto.

Both sidewalls of the peripheral circuit gate stack PGS and the gate capping pattern 142P may be covered with an insulating spacer 150P. For example, the insulating spacer 150P may be formed on the substrate 110, and may extend on the top surface of the gate dielectric layer 118, and the sidewalls of the peripheral circuit gate stack PGS and the gate capping pattern 142P in the second horizontal direction Y. The insulating spacer 150P may include, for example, an oxide layer, a nitride layer, or a combination thereof. The peripheral circuit transistor PTR and the insulating spacer 150P may be covered by a protective layer 144P, and a first interlayer insulating layer 148 may be arranged on the protective layer 144P to fill a space between two adjacent peripheral circuit transistors PTR. A capping insulating layer 146P may be arranged on the first interlayer insulating layer 148 and the protective layer 144P.

As shown in FIGS. 2 and 5, contact plugs PCT may be respectively formed in contact holes PCTH penetrating the first interlayer insulating layer 148 and a capping insulating layer 146P in the vertical direction Z in the peripheral circuit region PCA to be connected to the substrate 110. For example, the contact plugs PCT may be disposed adj acent to the peripheral circuit gate stack PGS and connected to the source and drain regions of the substrate 110. The contact plugs PCT may include a conductive barrier layer and a landing pad conductive layer, in a manner the same as that of the plurality of landing pads LP formed in the cell array region MCA. A metal silicide layer may be arranged between the second active region AC2 and each of the contact plugs PCT. An upper interlayer insulating layer 190 covering the contact plugs PCT may be arranged on the capping insulating layer 146P.

In general, as the line width of the plurality of bit lines BL decreases and the spacing between the bit lines BL decreases, it is difficult to precisely control the process of patterning the bit line contact DC and/or forming the buried contact hole BCH. When an inner spacer is formed on the sidewall of the bit line contact DC, by using silicon nitride (Si₃N₄), the inner spacer may not be sufficiently removed from the bottom of the buried contact hole BCH so as to penetrate the bit line contact spacer, in the process of forming the buried contact hole BCH, resulting in defects such as not exposing the surface of a substrate or exposing the surface of the substrate with a relatively small area.

According to the embodiments described above, the anti-oxidation layers 138 may be formed on the sidewalls of each of the bit lines BL by a silicon (Si) precursor supply process to prevent unwanted oxidation of the sidewalls of each of the bit lines BL, such as the upper conductive layer 136. For example, as shown in Chemical Equation 1 above, the metal oxide (MOₓ) formed on the sidewalls of the bit lines BL may be reduced by the silicon (Si) precursor to regenerate the metal (M) of the bit lines BL. In addition, since an inner spacer using silicon nitride (Si₃N₄) is not formed on the sidewall of the bit line contact DC, the bit line contact spacer 160 may be sufficiently removed in the process of forming the buried contact hole BCH so as to penetrate the bit line contact spacer 160, and a sufficiently large contact area between the buried contact BC and the first active region AC1 may be secured.

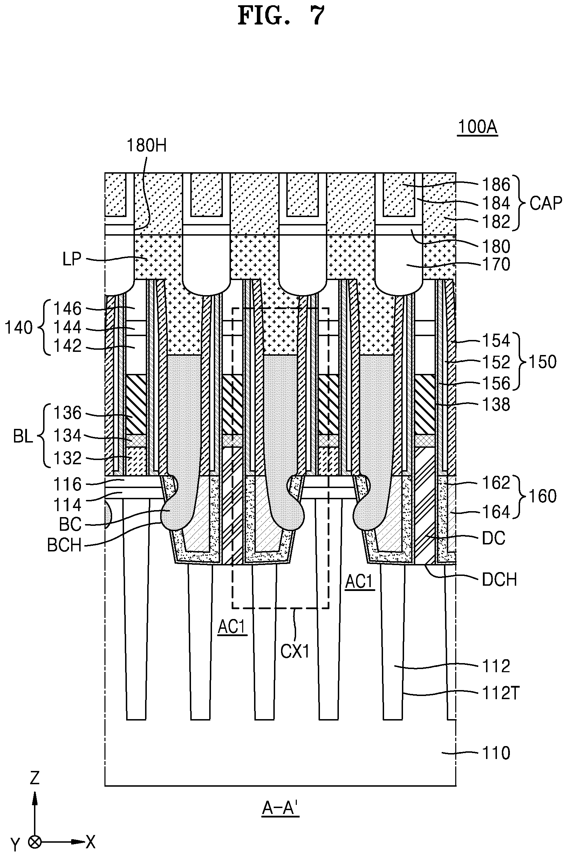

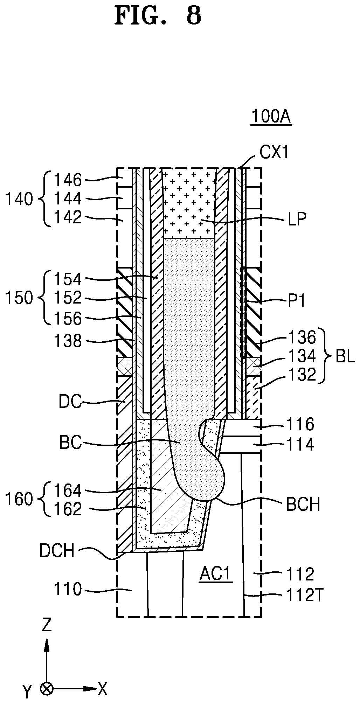

FIGS. 7 and 8 are cross-sectional views illustrating a semiconductor device 100A according to an embodiment of the present inventive concept.

Referring to FIGS. 7 and 8, the bit line spacer 150 may further include a third spacer layer 156, and the third spacer layer 156 may be arranged between the first spacer layer 152 and the anti-oxidation layer 138.

The third spacer layer 156 may be conformally arranged on the sidewall of the anti-oxidation layer 138 and have an end extending onto the top surface of the insulating liner 162 of the bit line contact spacer 160. The first spacer layer 152 and the second spacer layer 154 may be sequentially arranged on the third spacer layer 156.

In an embodiment of the present inventive concept, the third spacer layer 156 may include silicon nitride (Si₃N₄). In an embodiment of the present inventive concept, the third spacer layer 156 may have a thickness of about 0.5 nm to about 2 nm.

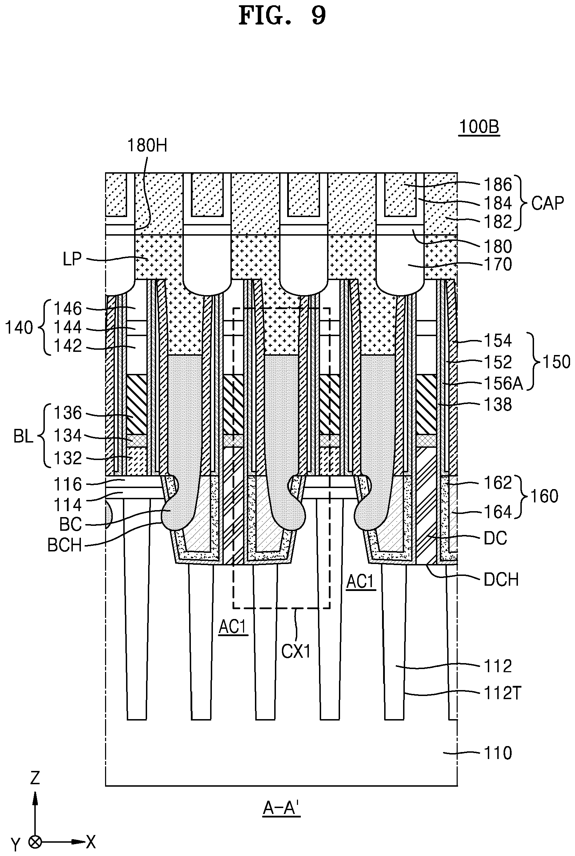

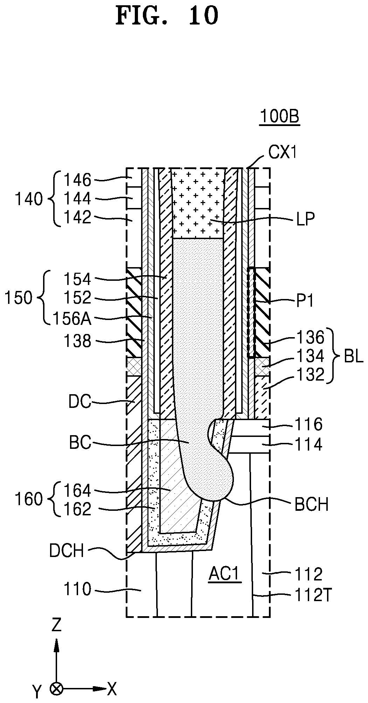

FIGS. 9 and 10 are cross-sectional views illustrating a semiconductor device 100B according to an embodiment of the present inventive concept.

Referring to FIGS. 9 and 10, the bit line spacer 150 may further include a third spacer layer 156A, and the third spacer layer 156A may be arranged between the first spacer layer 152 and the anti-oxidation layer 138.

In an embodiment of the present inventive concept, the third spacer layer 156A may include a silicon-containing material, for example, the silicon-containing material may be represented by a formula of SiOₓ (0<x≦2). For example, the silicon-containing material may be represented by a formula of SiO_{q} (0<q<2). In an embodiment of the present inventive concept, the third spacer layer 156A may further include impurities of chlorine (Cl) and/or carbon (C). For example, the impurities may be residue of chlorine (Cl) atoms and/or carbon (C) atoms included in the silicon (Si) precursor supplied in a process of forming the third spacer layer 156A.

In an embodiment of the present inventive concept, the third spacer layer 156A may include a silicon-containing material formed by a process of supplying a silicon (Si) precursor onto the top surface of the anti-oxidation layer 138. For example, the third spacer layer 156A may be formed by forming the anti-oxidation layer 138 and then forming the bit line contact spacer 160 in the bit line contact hole DCH and then performing an additional silicon precursor supply process on the surface of the anti-oxidation layer 138 placed on the sidewalls of each of the bit lines BL.

In an embodiment of the present inventive concept, as both the third spacer layer 156A and the anti-oxidation layer 138 are formed by the silicon precursor supply process, the boundary between the third spacer layer 156A and the anti-oxidation layer 138 may not be visually identifiable.

In an embodiment of the present inventive concept, the third spacer layer 156A may have a thickness of about 0.5 nm to about 2 nm.

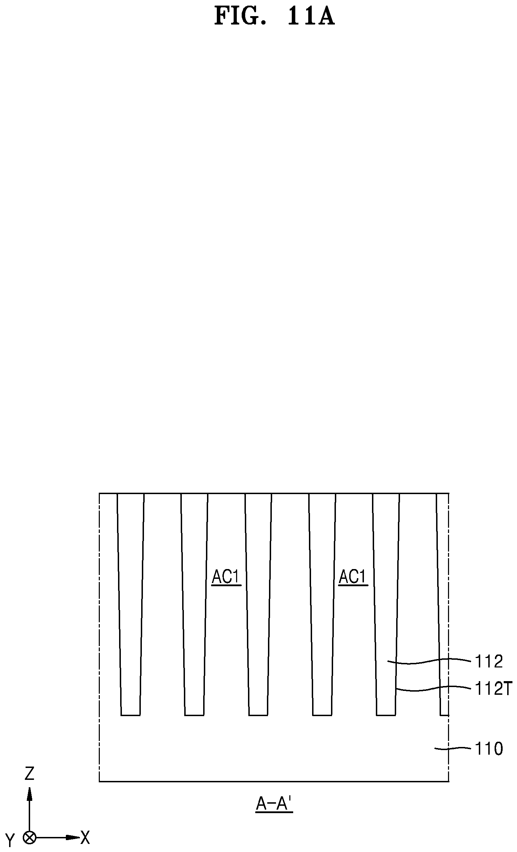

FIGS. 11A, 11B, 12A, 12B, 13A, 13B, 14A, 14B, 15 to 21, 22A, 22B, 23A, 23B, 24A, and 24B are cross-sectional views illustrating a method of manufacturing a semiconductor device 100, according to an embodiment of the present inventive concept. For example, FIGS. 11A, 12A, 13A, 14A, 15 to 21, 22A, 23A, and 24A are cross-sectional views corresponding to a cross-section taken along line A-A' of FIG. 2, and FIGS. 11B, 12B, 13B, 14B, 22B, 23B, and 24B are cross-sectional views corresponding to a cross-section taken along line B-B' of FIG. 2.

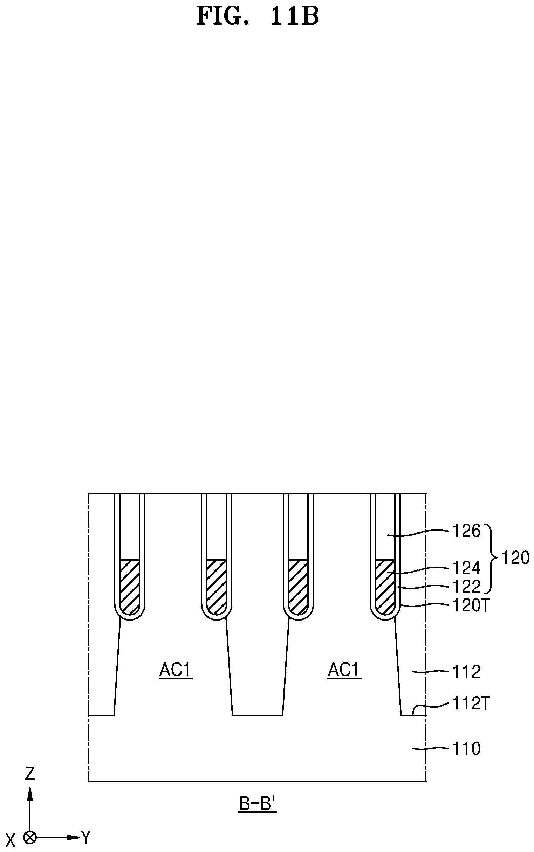

Referring to FIGS. 11A and 11B, a plurality of device isolating trenches 112T may be formed in the substrate 110.

Then, first device isolation layers 112 filling the plurality of device isolation trenches 112T may be formed. A plurality of first active regions AC1 may be defined in the substrate 110 by forming the first device isolation layers 112. In a plan view, the plurality of first active regions AC1 may extend in a first diagonal direction D1 (see FIG. 2) inclined at a predetermined angle with the first horizontal direction X and the second horizontal direction Y. In addition, the plurality of first active regions AC1 may be in the form of a plurality of bars extending parallel to each other, and the substantially center portion of one of the plurality of first active regions AC1 may be disposed adjacent to an end portion of another first active region AC1.

In an embodiment of the present inventive concept, the first device isolation layers 112 may be formed using, for example, silicon oxide (SiO₂), silicon nitride (Si₃N₄), silicon oxynitride (SiON), or a combination thereof. In an embodiment of the present inventive concept, the first device isolation layers 112 may be formed having a double layer structure of a silicon oxide (SiO₂) layer and a silicon nitride (Si₃N₄) layer, but the present inventive concept is not limited thereto.

A mask pattern may be formed on the substrate 110, and a portion of the substrate 110 may be removed by using the mask pattern as an etching mask to form word line trenches 120T. The mask pattern may be formed by a photolithography process and an etching process. For example, the mask pattern for forming the word line trenches 120T may be formed using double patterning technology (DPT) or quadruple patterning technology (QPT), but the present inventive concept is not limited thereto.

Thereafter, the gate dielectric layer 122, the gate electrode 124, and the word line capping layer 126 forming the buried gate structure 120 may be sequentially formed in each of the word line trenches 120T.

The gate dielectric layer 122 may be conformally arranged on the inner wall of the word line trench 120T. The gate electrode 124 may be formed by filling the word line trench 120T with a conductive layer, and then etching back the upper part of the conductive layer to expose a part of the upper side of the word line trench 120T again. The etching back process may be performed until the conductive layer is formed to have a required thickness in the lower portion of the word line trench 120T.

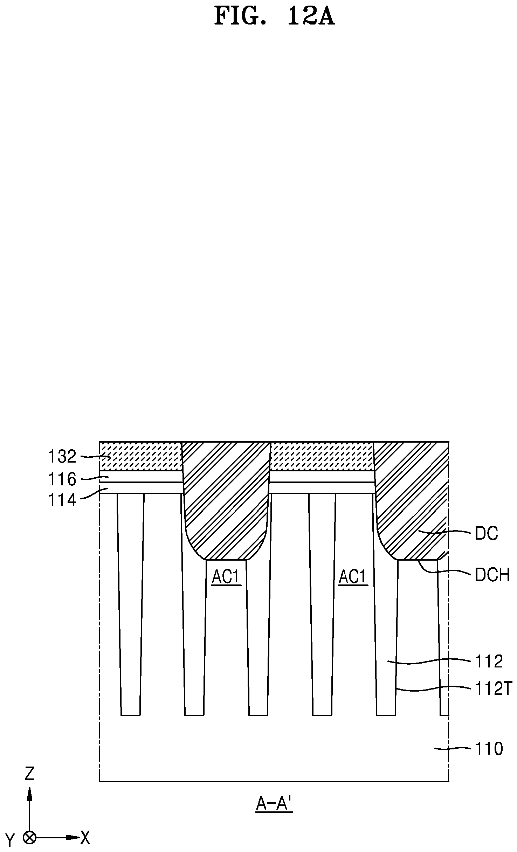

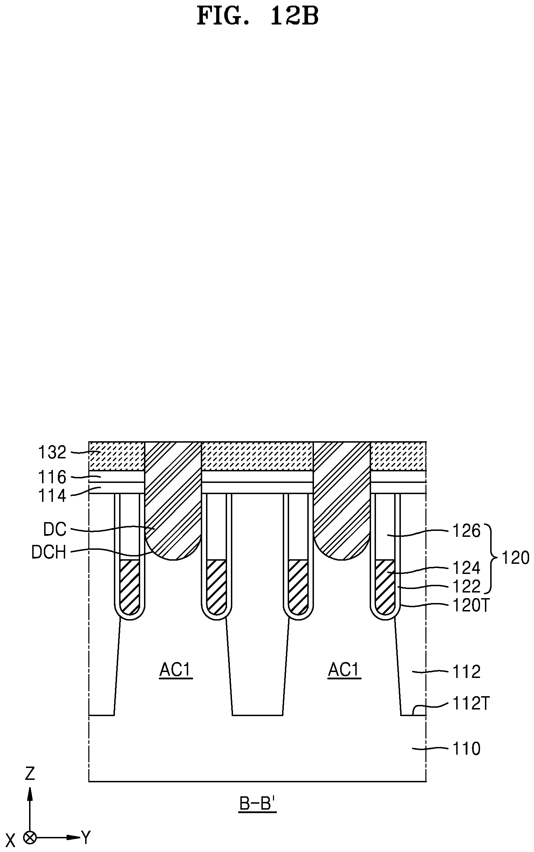

Referring to FIGS. 12A and 12B, the first buffer insulating layer 114 and the second buffer insulating layer 116 may be formed on the first active region AC1 and the first device isolation layers 112. Thereafter, the lower conductive layer 132 may be formed on the first and second buffer insulating layers 114 and 116. Portions of the lower conductive layer 132, the first and second buffer insulating layers 114 and 116, and the substrate 110 may be removed to form bit line contact holes DCH. For example, the bit line contact holes DCH may each be formed at the substantially center portion of each of the first active regions AC1 and formed between two adjacent buried gate structures 120 in a plan view. Thereafter, the bit line contacts DC may be formed in the bit line contact holes DCH by using a conductive material.

In an embodiment of the present inventive concept, the lower conductive layer 132 may be formed using at least one of, for example, silicon (Si), germanium (Ge), tungsten (W), tungsten nitride (WN), cobalt (Co), nickel (Ni), aluminum (Al), molybdenum (Mo), ruthenium (Ru), titanium (Ti), titanium nitride (TiN), tantalum (Ta), tantalum nitride (TaN), copper (Cu), or a combination thereof. In an embodiment of the present inventive concept, the bit line contacts DC may be formed using, for example, titanium nitride (TiN), titanium silicon nitride (TiSiN), tungsten (W), tungsten silicide (WSi₂), doped polysilicon (p-Si), or a combination thereof.

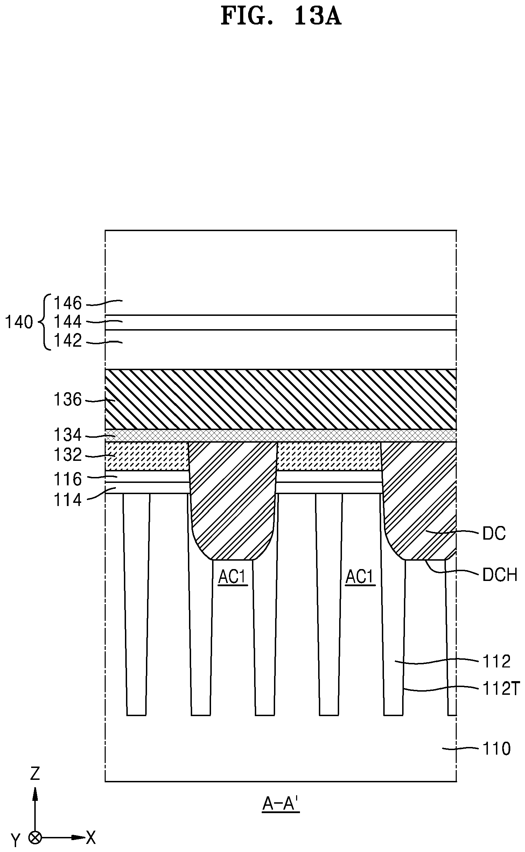

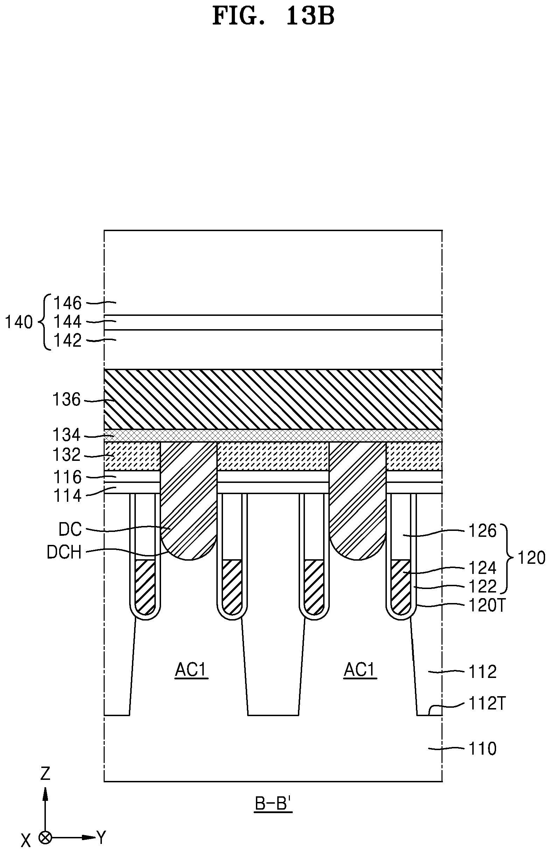

Referring to FIGS. 13A and 13B, a metal silicide layer 134 may be formed on the bit line contacts DC and the lower conductive layer 132. The metal silicide layer 134 may be formed using at least one of, for example, cobalt silicide (CoSi₂), nickel silicide (NiSi₂), titanium silicide (TiSi₂), tantalum silicide (TaSi₂), or tungsten silicide (WSi₂). Optionally, at least one of, for example, titanium (Ti), titanium nitride (TiN), niobium nitride (NbN), tungsten nitride (WN), or tantalum nitride (TaN) may be used to further form a conductive barrier layer on the metal silicide layer 134.

Thereafter, the upper conductive layer 136 may be formed on the metal silicide layer 134. In an embodiment of the present inventive concept, the upper conductive layer 136 may include at least one of, for example, tungsten (W), ruthenium (Ru), molybdenum (Mo), titanium (Ti), rhodium (Ro), iridium (Ir), or alloys thereof. The upper conductive layer 136 may be formed using at least one of, for example, a physical vapor deposition (PVD) process, a chemical vapor deposition (CVD) process, or an atomic layer deposition (ALD) process.

Thereafter, the bit line capping layer 140 may be formed on the upper conductive layer 136. The bit line capping layer 140 may include the first capping layer 142, the second capping layer 144, and the third capping layer 146 sequentially arranged on the upper conductive layer 136. The first capping layer 142, the second capping layer 144, and the third capping layer 146 may be formed using at least one of, for example, silicon nitride (Si₃N₄), silicon oxide (SiO₂), or silicon oxynitride (SiON).

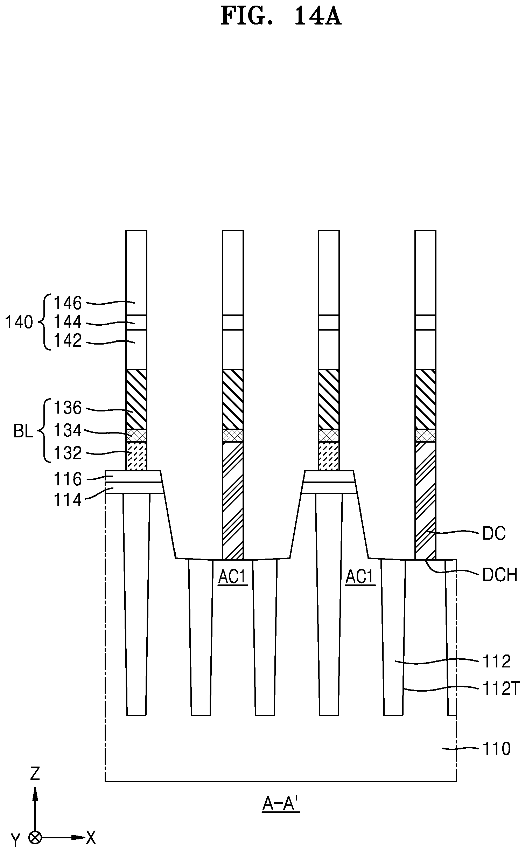

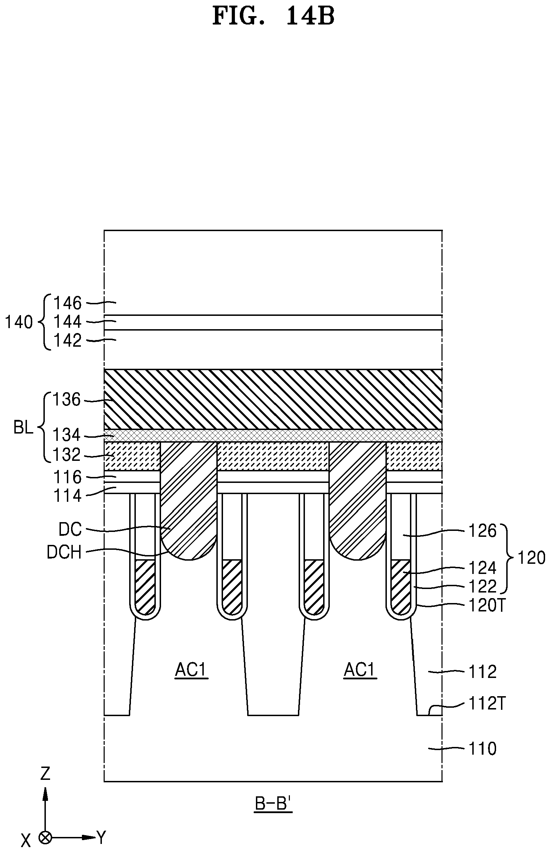

Referring to FIGS. 14A and 14B, the plurality of bit lines BL may be formed by patterning the upper conductive layer 136, the metal silicide layer 134, and the lower conductive layer 132 using the bit line capping layers 140 as etching masks. The first and second buffer insulating layers 114 and 116 may work as an etch-stop film.

In the patterning process for forming the plurality of bit lines BL, portions of the bit line contacts DC arranged in the bit line contact holes DCH may also be removed. Accordingly, as shown in FIG. 14A, the sidewall of each of the bit line contacts DC may be formed to be aligned with the sidewall of each of the bit lines BL, and the inner wall of each of the bit line contact holes DCH (e.g., the surface of the substrate 110) may be exposed on both sides of each of the bit line contacts DC. For example, after the patterning process, the bit lines BL and the bit line contacts DC may be formed on and connected to the substrate 110, and extending in the second horizontal direction Y in the cell array regions MCA.

Selectively, a cleaning process may be performed after a patterning process of the bit lines BL. The cleaning process may be performed to remove etching residue from the patterning process, and for example, may be performed by a rinse process using a wet cleaning solution.

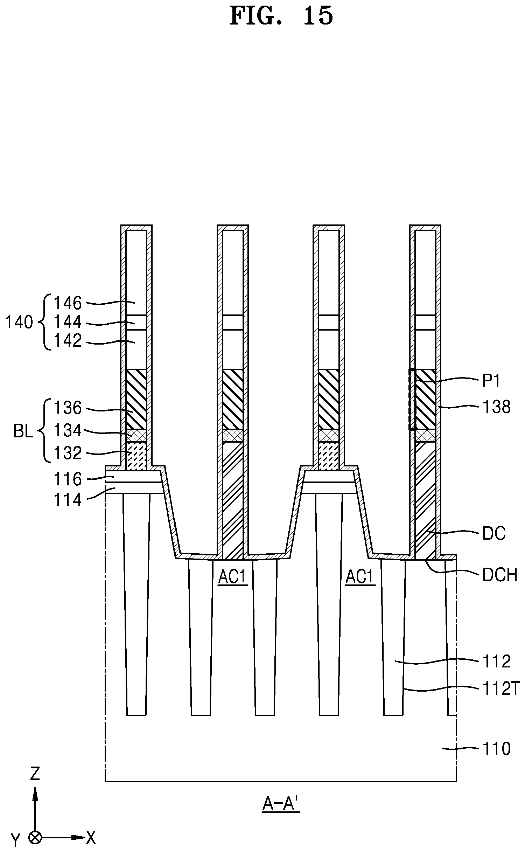

Referring to FIG. 15, the anti-oxidation layers 138 may be formed on the sidewalls of the bit lines BL, the bit line capping layers 140, and the bit line contacts DC.

In an embodiment of the present inventive concept, the anti-oxidation layers 138 may be formed by performing a silicon (Si) precursor supply process. In an embodiment of the present inventive concept, the silicon (Si) precursor supplied in the silicon (Si) precursor supply process may include, but is not limited to, for example, silane (SiH₄), disilane (Si₂H₆), trisilane (Si₃H₈), dichlorosilane (DCS), trichlorosilane (TCS), diisopropyl aminosilane (DIPAS), and the like.

In an embodiment of the presentive concept, the silicon (Si) precursor supply process may include supplying a silicon (Si) precursor onto a reaction chamber in which a substrate is arranged, and removing or purging the silicon (Si) precursor from the reaction chamber. In an embodiment of the present inventive concept, the silicon (Si) precursor supply process may be carried out by repeating a unit supply cycle including the silicon (Si) precursor supply step and the purge step one time to tens of times. The silicon (Si) precursor supply process may be performed until a silicon-containing material is formed to a thickness of about 0.1 nm to about 2 nm.

In an embodiment of the present inventive concept, the anti-oxidation layers 138 may include a silicon-containing material, and the silicon-containing material may be represented by a chemical formula of SiOₓ (0 < x ≦ 2). In an embodiment of the present inventive concept, the anti-oxidation layer 138 may further include impurities including chlorine (Cl) and/or carbon (C). For example, the impurities may be residue of chlorine (Cl) atoms and/or carbon (C) atoms included in the silicon (Si) precursor supplied during the formation process of the anti-oxidation layers 138.

In an embodiment of the present inventive concept, a silicon oxide (SiO₂) may be formed by a reduction reaction between a silicon precursor supplied on the sidewall of the upper conductive layer 136 and a metal oxide (e.g., a metal oxide formed on the surface of the upper conductive layer 136 as the result of the previous patterning process and/or selectively performed cleaning process). For example, the metal oxide may be reduced by the silicon (Si) precursor to regenerate the metal of the upper conductive layer 136. For example, a reduction reaction according to the following Chemical Equation 1 may occur on the surface of the upper conductive layer 136, and at least a portion of the anti-oxidation layer 138 (for example, the first portion P1 of the anti-oxidation layer 138) may include a material formed by the following Chemical Equation 1.

MOₓ + Si → M + SiO_{y} - (Chemical Equation 1)

Here, M may correspond to an element of a metal material included in the bit lines BL. The anti-oxidation layer 138 including silicon containing material SiO_{y} (0 < y ≦ 2) may be formed on the side wall of the bit line BL. In Chemical Equation 1, x may be equal to y. The upper conductive layer 136 may include the metal material represented by M.

For example, when the upper conductive layer 136 included in each of the bit lines BL includes tungsten (W), the first portion P1 of the anti-oxidation layer 138 placed on the sidewall of the upper conductive layer 136 by a reduction reaction under Chemical Equation 2 below may include silicon oxide (SiO₂).

2WO₃ + 3Si → 2W + 3SiO₂ - (Chemical Equation 2)

In an embodiment of the present inventive concept, depending on the amount of metal oxide formed on the sidewall of the bit line BL, when sufficient silicon (Si) precursor is supplied to form the anti-oxidation layer 138 to reduce tungsten oxide (WO₃), the reduction reaction may be represented by Chemical Equation 3 below.

2WO₃ + zSi → 2W + zSiO_{6/z} - (Chemical Equation 3)

In Chemical Equation 3, z is equal to or greater than 3.

In an embodiment of the present inventive concept, the anti-oxidation layers 138 may be conformally arranged on the sidewall of each of the plurality of bit lines BL, on the sidewall of each of the plurality of bit line capping layers 140, and on the inner wall of each of the bit line contact holes DCH. In an embodiment of the present inventive concept, the anti-oxidation layer 138 may be arranged on the sidewall of each of the bit line contacts DC arranged to be aligned with the sidewall of each of the plurality of bit lines BL.

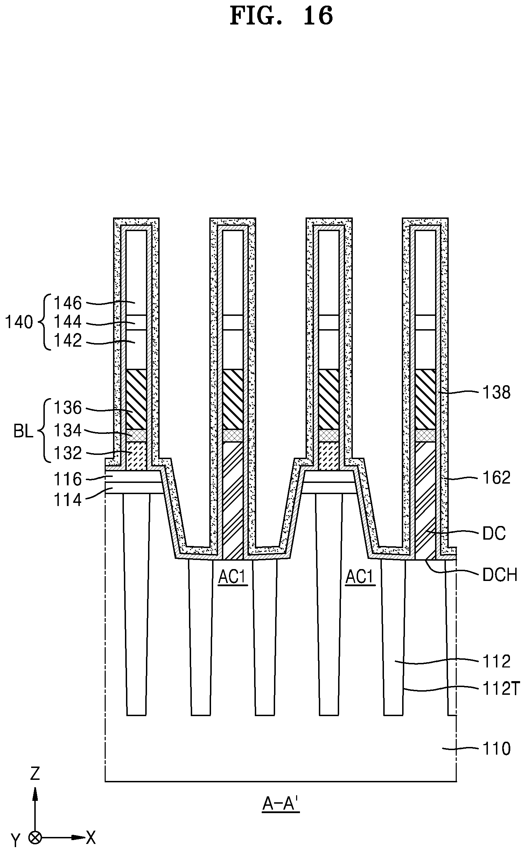

Referring to FIG. 16, the insulating liner 162 may be conformally formed on the plurality of bit lines BL and the plurality of bit line capping layers 140 and on the inner walls of the bit line contact holes DCH. The insulating liner 162 may be arranged to be in contact with the anti-oxidation layer 138.

In an embodiment of the present inventive concept, the insulating liner 162 may include silicon oxide (SiO₂).

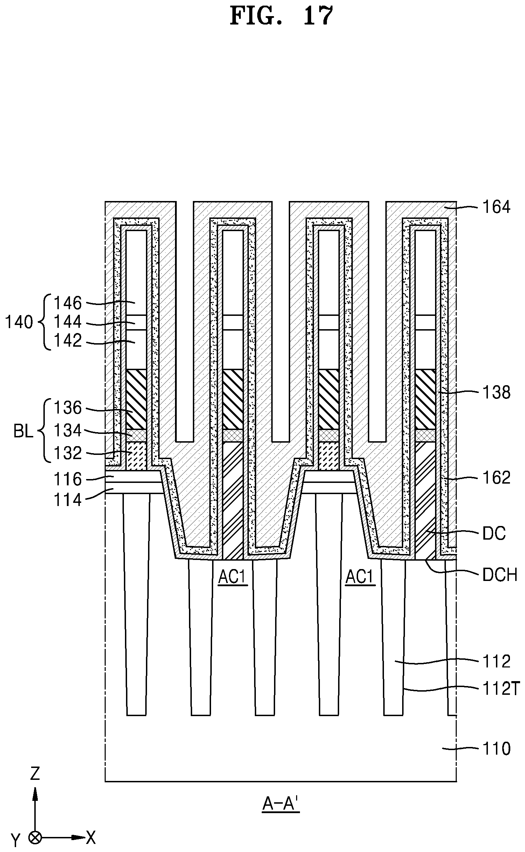

Referring to FIG. 17, a buried spacer 164 may be formed on the plurality of bit lines BL and the plurality of bit line capping layers 140 and on the inner walls of the bit line contact holes DCH. The buried spacer 164 may be in contact with the insulating liner 162 and may be formed to be thick enough to completely fill the inside of the bit line contact holes DCH.

In an embodiment of the present inventive concept, the buried spacer 164 may include silicon nitride (Si₃N₄).

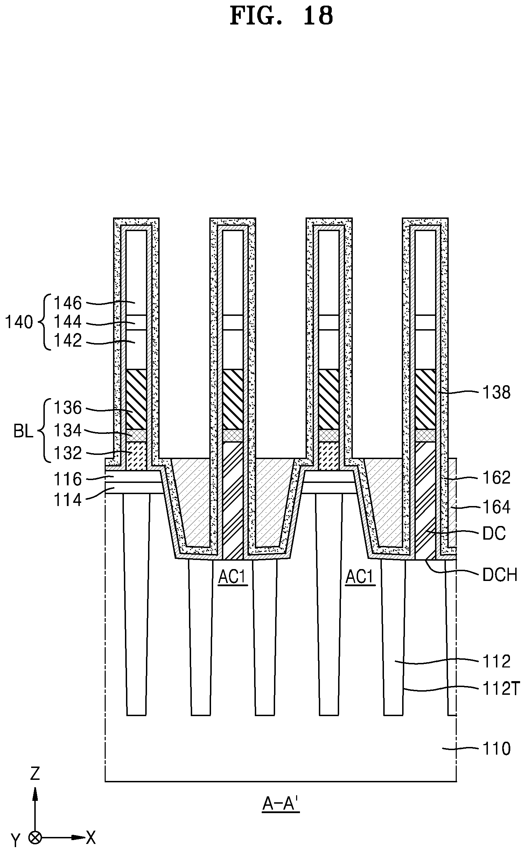

Referring to FIG. 18, the buried spacer 164 arranged on the sidewalls of the plurality of bit lines BL and the plurality of bit line capping layers 140 may be removed, and only a portion of the buried spacer 164 arranged inside the bit line contact holes DCH may remain.

In an embodiment of the present inventive concept, the process of removing a portion of the buried spacer 164 may be an etching process using an etchant having an etch selectivity with respect to the insulating liner 162. For example, the etch rate for the buried spacer 164 is substantially higher than that of the insulating liner 162 under the etch condition using the etchant. For example, in the process of removing a portion of the buried spacer 164, the portion of the insulating liner 162 arranged on the sidewalls of the plurality of bit lines BL and the plurality of bit line capping layers 140 may remain by not being removed. For example, the silicon nitride (Si₃N₄) of the buried spacer 164 may be selectively removed over the silicon oxide (SiO₂) of the insulating liner 162 with phosphoric acid (H₃PO₄) in a wet etching process, or with mixtures of oxygen (O₂), nitrogen (N₂) and a fluorine source gas such as carbon tetrafluoride (CF₄) or nitrogen trifluoride (NF₃) in a dry etching process. However, the present inventive concept is not limited thereto.

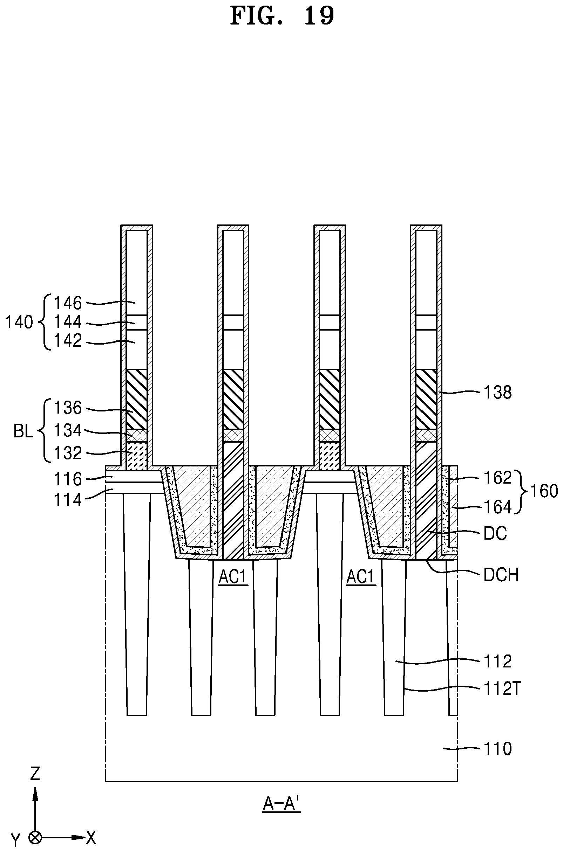

Referring to FIG. 19, the portion of the insulating liner 162 arranged on the sidewalls of the plurality of bit lines BL and the plurality of bit line capping layers 140 may be removed, and only the portion of the insulating liner 162 arranged inside the bit line contact holes DCH may remain.

In an embodiment of the present inventive concept, in the process of removing a portion of the insulating liner 162, the sidewalls of the bit lines BL may be covered by the anti-oxidation layer 138 so as not to be exposed to an etching atmosphere.

Here, the insulating liner 162 and the buried spacer 164 arranged in the bit line contact hole DCH may be referred to as a bit line contact spacer 160.

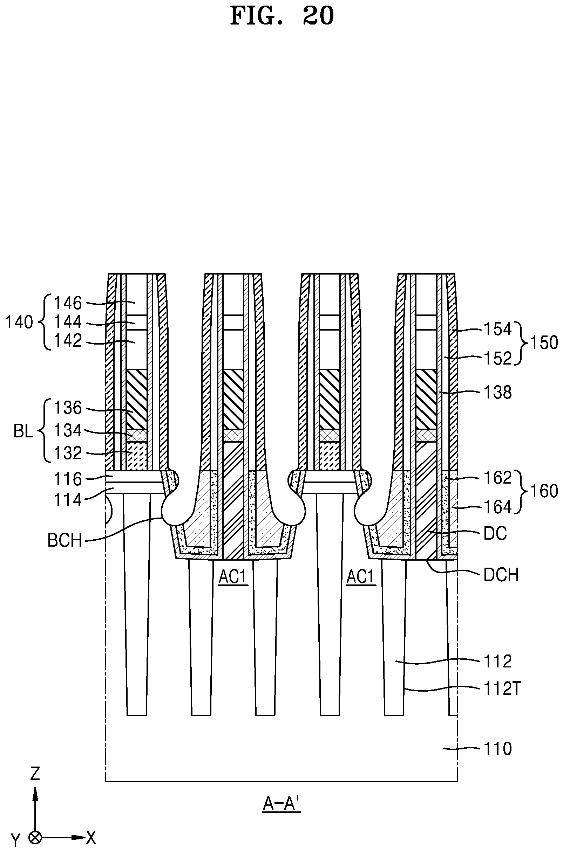

Referring to FIG. 20, a first spacer layer 152 may be formed on the sidewalls of the bit lines BL and the bit line capping layers 140. In an embodiment of the present inventive concept, the first spacer layer 152 may be arranged on a sidewall of the anti-oxidation layer 138 and including silicon oxide (SiO₂) or formed using silicon oxide (SiO₂). The first spacer layer 152 may be in contact with the anti-oxidation layer 138, and the anti-oxidation layer 138 may be arranged between the first spacer layer 152 and the bit line BL. The first spacer layer 152 may be formed using a chemical vapor deposition (CVD) process or an atomic layer deposition (ALD) process.

Then, a second spacer layer 154 may be formed on the sidewall of the first spacer layer 152. In an embodiment of the present inventive concept, the second spacer layer 154 may include or may be formed using silicon nitride (Si₃N₄). The second spacer layer 154 may be formed using a chemical vapor deposition (CVD) process or an atomic layer deposition (ALD) process.

Thereafter, a portion of the bit line contact spacer 160 arranged between the bit lines BL may be removed to expose the top portion of the first active region AC1 and form a buried contact hole BCH.

In an embodiment of the present inventive concept, the process of forming the buried contact hole BCH may include a wet etching process, a dry etching process, or a combination thereof. In the etching process for forming the buried contact hole BCH, a portion of the upper side of the bit line capping layer 140 may also be removed, thereby lowering the top surface level of the bit line capping layer 140.

In an embodiment of the present inventive concept, a process of forming the buried contact hole BCH may include a first etching process for removing a portion of the buried spacer 164, a second etching process for removing a portion of the insulating liner 162, and a third etching process for removing a portion of the anti-oxidation layer 138. A portion of the first active region AC1 may also be removed in the process of forming the buried contact hole BCH.

In an embodiment of the present inventive concept, the buried contact hole BCH may extend to penetrate the bit line contact spacer 160 in a direction toward the sidewall of the bit line contact hole DCH, and the bottom of the buried contact hole BCH may have a curved profile protruding laterally in a direction toward the first active region AC1 with respect to the sidewall of the bit line contact hole DCH.

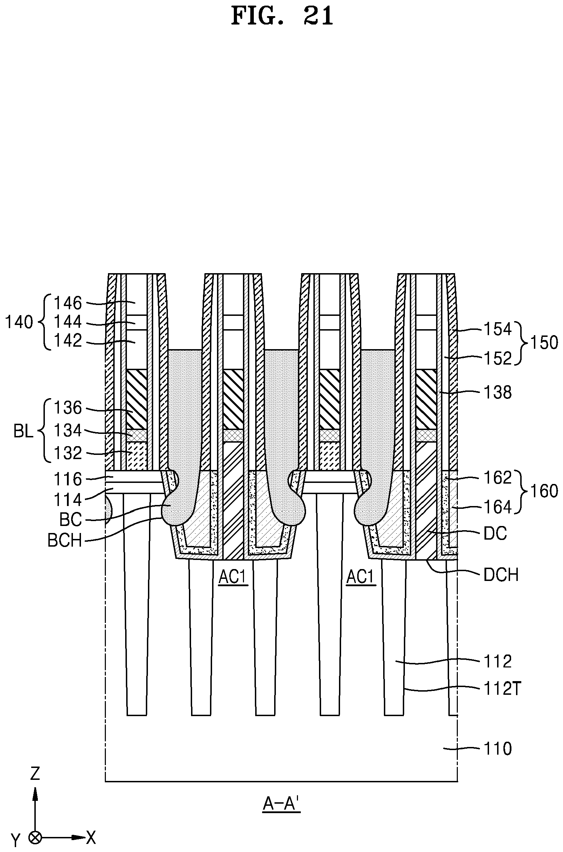

Referring to FIG. 21, buried contacts BC filling the inside of the buried contact holes BCH may be formed. In an embodiment of the present inventive concept, the buried contacts BC may be formed using a doped polysilicon (p-Si).

In an embodiment of the present inventive concept, the buried contact hole BCH is formed to have a line-type planar shape placed between adjacent bit lines BL (e.g., between adjacent bit line spacers 150), and then a preliminary contact layer having a line-type planar shape may be formed in the buried contact hole BCH, and the preliminary contact layer may be patterned to form the buried contact BC. Thereafter, an insulating fence may be formed using an insulating material in the space between the buried contacts BC (for example, a space from which a portion of the preliminary contact layer is removed).

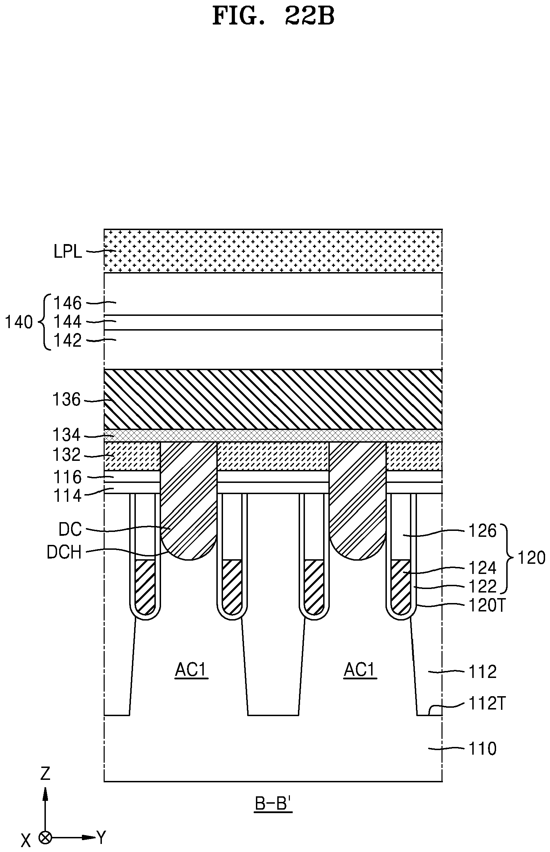

In an embodiment of the present inventive concept, before forming the buried contact hole BCH, a plurality of insulating fences may be formed using an insulating material at the intersection of a space between two adjacent bit lines BL and the word line trenches 120T (refer to FIG. 22B), a buried contact hole BCH may be formed by removing a portion of the substrate 110 arranged between the plurality of bit lines BL and between the plurality of insulating fences, and then the buried contact BC may be formed in the buried contact hole BCH.

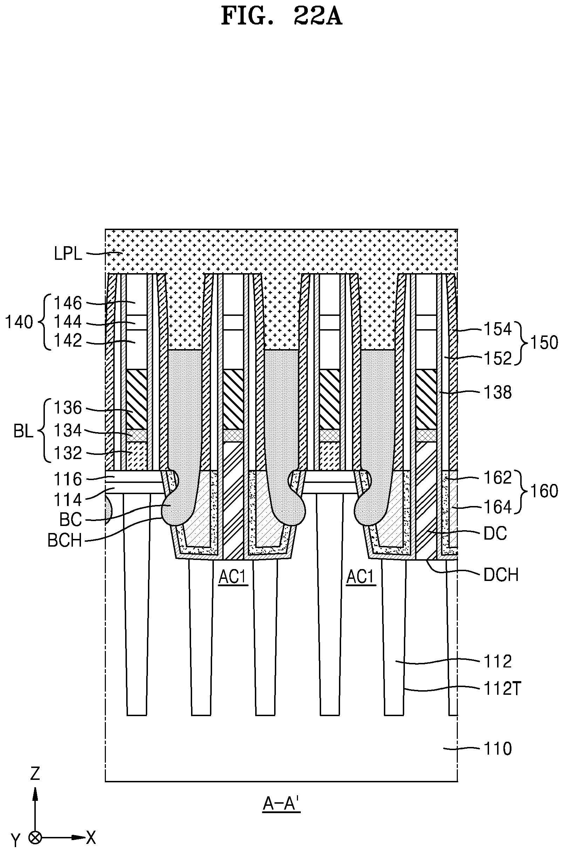

Referring to FIGS. 22A and 22B, a landing pad conductive layer LPL may be formed on the top surfaces of the plurality of buried contacts BC. The landing pad conductive layer LPL may be formed to have a sufficient thickness to contact the buried contacts BC and cover the top surfaces of the bit line capping layers 140.

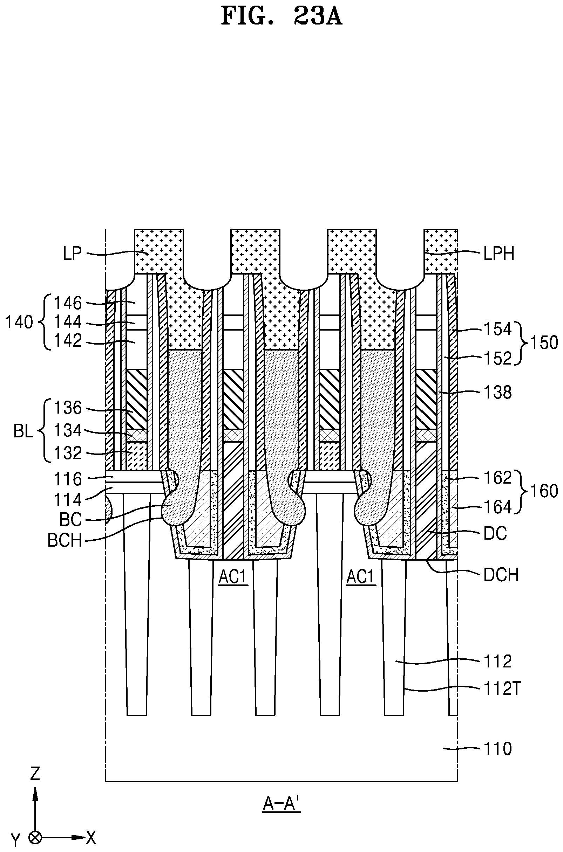

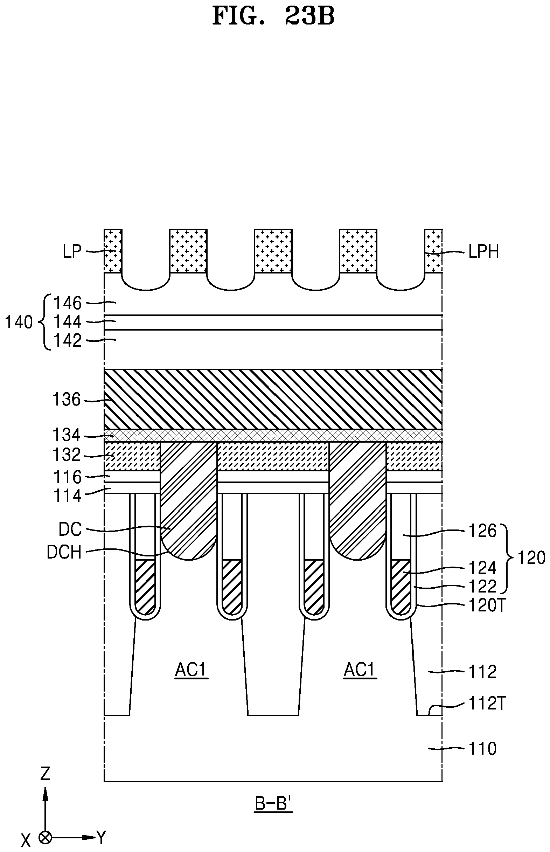

Referring to FIGS. 23A and 23B, a mask pattern may be formed on the landing pad conductive layer LPL, and the landing pad conductive layer LPL may be patterned using the mask pattern as an etching mask to form landing pad openings LPH. A plurality of landing pads LP, which are arranged on the plurality of buried contacts BC, respectively, may be formed by the landing pad openings LPH. Each of the plurality of landing pads LP may then be disposed on a portion of an upper surface of the bit line capping layer 140 and on an upper surface of the buried contact BC. Like the buried contacts BC, the landing pads LP may form a plurality of isolated regions spaced apart from each other.

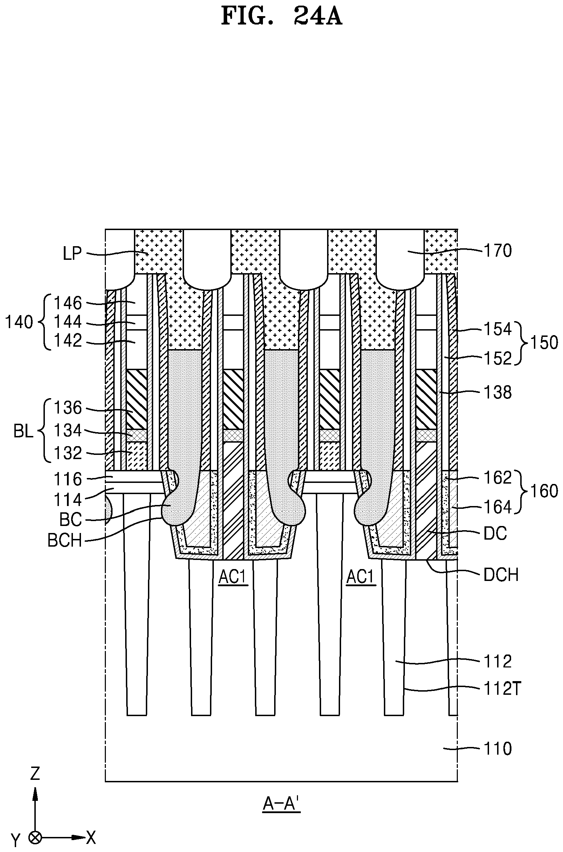

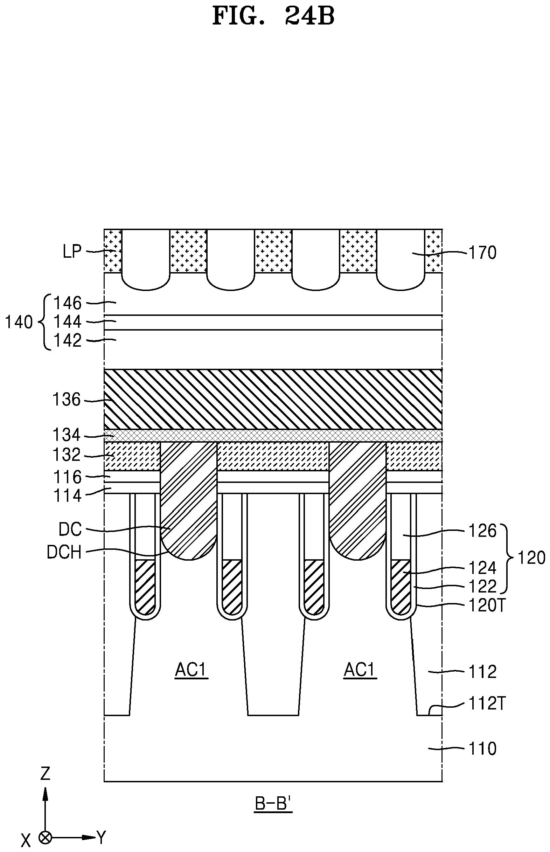

Referring to FIGS. 24A and 24B, an insulating pattern 170 may be formed in the landing pad openings LPH by using an insulating material. The insulating pattern 170 may be arranged to cover sidewalls of the plurality of landing pads LP. For example, the insulating pattern 170 may separate the landing pads LP from each other.

Referring back to FIGS. 3 and 4, an etching stop layer 180 may be formed on the insulating pattern 170, and the etching stop layer 180 may include openings 180H. The openings 180H may be arranged at positions corresponding to the respective landing pads LP, and a top surface of each of the landing pads LP may be arranged on the bottom of each of the openings 180H.

Referring back to FIGS. 3 and 4, a plurality of lower electrodes 182 connected to the landing pads LP may be formed, and a capacitor dielectric layer 184 and an upper electrode 186 may be sequentially formed on sidewalls of each of the plurality of lower electrodes 182. The lower electrode 182 may be arranged such that the bottom of the lower electrode 182 is arranged in each of the openings 180H of the etching stop layer 180, and thus, the bottom of the lower electrode 182 is placed on each of the landing pads LP.

The semiconductor device 100 may be completely formed by performing the above-described method.

According to an embodiment of the present inventive concept, the anti-oxidation layer 138 may be formed on the sidewall of each of the bit lines BL by a silicon (Si) precursor supply process to prevent unwanted oxidation of the sidewall of each of the bit lines BL, for example, the upper conductive layers 136. In addition, since an inner spacer using silicon nitride (Si₃N₄) is not formed on the sidewall of the bit line contact DC, the bit line contact spacer 160 may be sufficiently removed in the process of forming the buried contact hole BCH so as to penetrate the bit line contact spacer 160, and a sufficiently large contact area between the buried contact BC and the first active region AC1 may be secured.

In an embodiment of the present inventive concept, after performing the process described with reference to FIGS. 11A to 19, a silicon (Si) precursor supply process may be performed on sidewalls of the bit lines BL (for example, on a top surface of the anti-oxidation layer 138 arranged on the sidewall of each of the bit lines BL) to form a third spacer layer 156A, and then a first spacer layer 152 and a second spacer layer 154 covering the third spacer layer 156A may be sequentially formed. The third spacer layer 156A may include a silicon-containing material, for example, the silicon-containing material may be represented by a formula of SiOₓ (0<x≦2). In this case, the semiconductor device 100B described with reference to FIGS. 9 and 10 may be formed.

In an embodiment of the present inventive concept, after performing the process described with reference to FIGS. 11A to 19, the third spacer layer 156 may be formed using silicon nitride (Si₃N₄) on the sidewall of each of the bit lines BL (e.g., on the top surface of the anti-oxidation layer 138 arranged on the sidewall of each of the bit lines BL), and then the first spacer layer 152 and the second spacer layer 154 covering the third spacer layer 156 may be sequentially formed. In this case, the semiconductor device 100A described with reference to FIGS. 7 and 8 may be formed.

According to the semiconductor device of the present inventive concept, an anti-oxidation layer may be formed on the sidewall of each of the bit lines by a silicon (Si) precursor supply process to prevent unwanted oxidation of the sidewall of each of the bit lines, for example, the upper conductive layer including a metal material. In addition, since the inner spacer using silicon nitride (Si₃N₄) is not formed on the sidewall of the bit line contact, the bit line contact spacer may be sufficiently removed in the process of forming a buried contact hole to penetrate the bit line contact spacer, and a sufficiently large contact area may be secured between the buried contact and the first active region. Accordingly, the electrical connection between the buried contact and the first active region may be secured, and the occurrence of resistance defects may be prevented.

While the present inventive concept has been particularly shown and described with reference to embodiments thereof, it will be understood that various changes in form and details may be made therein without departing from the scope of the present inventive concept as defined by the appended claims.

## Claims

1. A semiconductor device comprising:
a substrate (110) including a first active region (AC1);
a bit line (BL) arranged on the substrate (110), crossing the first active region (AC1), and extending in a first direction (Y) parallel to a top surface of the substrate (110);
a bit line contact (DC) arranged between the bit line (BL) and the first active region (AC1), and arranged in a bit line contact hole (DCH), the bit line contact hole (DCH) extending into the substrate (110);
a bit line contact spacer (160) arranged on a sidewall of the bit line contact (DC) within the bit line contact hole (DCH);
a bit line spacer (150) arranged on a sidewall of the bit line (BL);
an anti-oxidation layer (138) arranged between the sidewall of the bit line (BL) and the bit line spacer (150) and between the sidewall of the bit line contact (DC) and the bit line spacer (150); and
a buried contact (BC) arranged in a buried contact hole (BCH), passing through the bit line contact spacer (160), and contacting the first active region (AC1),
wherein the anti-oxidation layer (138) includes a silicon-containing material, and the silicon-containing material includes SiOₓ, where 0 < x ≦ 2.

2. The semiconductor device of claim 1, wherein
the bit line (BL) comprises an upper conductive layer (136) including a metal material,
the anti-oxidation layer (138) includes a first portion (P1) arranged on a sidewall of the upper conductive layer (136), and
the first portion (P1) comprises silicon oxide, SiO₂.

3. The semiconductor device of claim 1 or 2, wherein
the silicon-containing material further comprises impurities, and
the impurities comprise at least one of carbon or chlorine.

4. The semiconductor device of any one of claims 1 to 3, wherein
the anti-oxidation layer (138) includes a second portion (P2) arranged on an inner wall of the bit line contact hole (DCH), and
the bit line contact spacer (160) comprises:
an insulating liner (162) arranged on the inner wall of the bit line contact hole (DCH), and arranged on the second portion (P2) of the anti-oxidation layer (138); and
a buried spacer (164) arranged on the inner wall of the bit line contact hole (DCH), and arranged on the insulating liner (162).

5. The semiconductor device of claim 4, wherein
the insulating liner (162) includes silicon oxide, and
the buried spacer (164) includes silicon nitride.

6. The semiconductor device of claim 4 or 5, wherein
the insulating liner (162) is arranged between the buried spacer (164) and the anti-oxidation layer (138), and
a bottom portion of the buried contact (BC) is covered by the buried spacer (164), the insulating liner (162), and the anti-oxidation layer (138).

7. The semiconductor device of any one of claims 4 to 6, wherein a bottom portion of the buried contact (BC) protrudes laterally toward the first active region (AC1) with respect to a sidewall of the bit line contact hole (DCH).

8. The semiconductor device of any one of claims 4 to 7, wherein the second portion (P2) of the anti-oxidation layer (138) is in contact with the sidewall of the bit line contact (DC).

9. The semiconductor device of any one of claims 1 to 8, wherein the bit line spacer (150) comprises:
a first spacer layer (152) arranged on a sidewall of the anti-oxidation layer (138) and including silicon oxide; and
a second spacer layer (154) arranged on a sidewall of the first spacer layer (152) and including silicon nitride.

10. The semiconductor device of claim 9, wherein the first spacer layer (152) is in contact with the sidewall of the anti-oxidation layer (138).

11. The semiconductor device of claim 9 or 10, wherein
the bit line spacer (150) further comprises a third spacer layer (156) arranged between the sidewall of the anti-oxidation layer (138) and the first spacer layer (152), and
the third spacer layer (156A) comprises silicon nitride.

12. The semiconductor device of claim 9 or 10, wherein
the bit line spacer (150) further comprises a third spacer layer (156A) arranged between the sidewall of the anti-oxidation layer (138) and the first spacer layer (152), and
the third spacer layer comprises a silicon-containing material, and the silicon-containing material includes SiOₓ (0<x≦2).

13. A semiconductor device comprising:
a substrate (110) including a plurality of first active regions (AC1);
a plurality of bit lines (BL) placed on the substrate (110), crossing the plurality of first active regions (AC1), and extending in a first direction (Y) parallel to a top surface of the substrate (110);
a bit line contact arranged between a first bit line among the plurality of bit lines (BL) and a first active region (AC1) among the plurality of first active regions (AC1), corresponding to the first bit line, and arranged within a bit line contact hole (DCH), the bit line contact hole (DCH) extending into the substrate (110);
an anti-oxidation layer (138) including a first portion (P1) arranged on a sidewall of the first bit line and a second portion (P2) arranged on an inner wall of the bit line contact hole (DCH);
a bit line contact spacer (160) arranged on the second portion (P2) of the anti-oxidation layer (138) and filling the bit line contact hole (DCH); and
a buried contact (BC) arranged between the first bit line and a second bit line adjacent to the first bit line among the plurality of bit lines (BL), arranged in a buried contact hole (BCH), passing through the bit line contact spacer (160) and the second portion (P2) of the anti-oxidation layer (138), and contacting the first active region (AC1),
wherein the anti-oxidation layer (138) includes a silicon-containing material, and the silicon-containing material includes SiOₓ, where 0 < x ≦ 2.

14. The semiconductor device of claim 13, wherein the first portion (P1) of the anti-oxidation layer (138) includes silicon oxide (SiO₂).

15. The semiconductor device of claim 13 or 14, wherein
the silicon-containing material further comprises impurities, and
the impurities comprise at least one of carbon or chlorine.
